(19) Europäisches Patentamt
European Patent Office
Office européen des brevets

(11) EP 4 596 592 A1

(12) EUROPEAN PATENT APPLICATION
published in accordance with Art. 153(4) EPC

(43) Date of publication:
**06.08.2025 Bulletin 2025/32**

(21) Application number: **23872141.9**

(22) Date of filing: **22.09.2023**

(51) International Patent Classification (IPC):
***C08F 220/30** (2006.01)* ***C08F 8/00** (2006.01)*
***C08F 220/22** (2006.01)* ***C08L 33/14** (2006.01)*
***C08L 33/16** (2006.01)* ***G03F 7/027** (2006.01)*
***H01L 21/336** (2006.01)* ***H01L 29/786** (2006.01)*
***H10K 10/40** (2023.01)* ***H10K 85/00** (2023.01)*

(52) Cooperative Patent Classification (CPC):
**C08F 8/00; C08F 220/22; C08F 220/30; C08L 33/14; C08L 33/16; G03F 7/027; H10D 30/021; H10D 30/67; H10K 10/40; H10K 85/00**

(86) International application number:
**PCT/JP2023/034409**

(87) International publication number:
**WO 2024/070915 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.09.2022 JP 2022152374**
**03.07.2023 JP 2023109247**

(71) Applicant: **Tosoh Corporation**
**Yamaguchi 746-8501 (JP)**

(72) Inventors:
- **LEE, Junghwi**
**Yokkaichi-shi, Mie 510-8540 (JP)**
- **FUKUDA, Takashi**
**Yokkaichi-shi, Mie 510-8540 (JP)**
- **OKU, Shinya**
**Yokkaichi-shi, Mie 510-8540 (JP)**

(74) Representative: **Novagraaf International SA**
**Chemin de l'Echo 3**
**1213 Onex, Geneva (CH)**

# (54) RESIN, COMPOSITION, PHOTOCROSSLINKED PRODUCT, PATTERN, AND ELECTRONIC DEVICE COMPRISING SAME

(57) An object of an aspect of the present invention is to provide a resin that has liquid-repellency and high solubility in an alkaline solution, and becomes insoluble in the solvent by photocrosslinking at low light exposure intensity. A resin in accordance with an aspect of the present invention contains: a repeating unit that is represented by Formula (1) including a photocrosslinkable group; and one or more units selected from the group consisting of a repeating unit that includes a fluorine atom, a repeating unit that includes an acidic functional group and a repeating unit that includes a hydrophilic functional group,

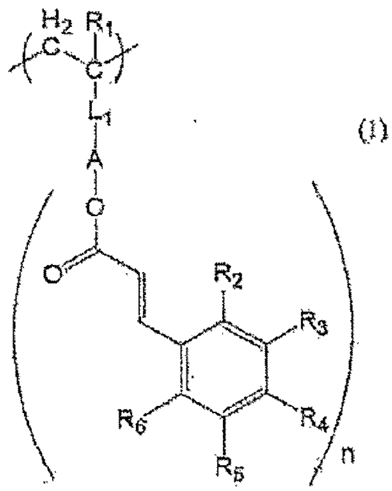

(1)

EP 4 596 592 A1

where $R_1$ represents hydrogen or methyl, $L_1$ represents a single bond or a linking group, A represents a linking group, and $R_2$ through $R_6$ represent one selected from the group consisting of hydrogen, halogen, alkyl, alkyl halide, alkoxy, aryl, aryloxy, cyano, and amino.

## Description

### Technical Field

The present invention relates to a resin. More specifically, the present invention relates to a resin that can be suitably used in an electronic device.

### Background Art

In recent years, there has been active development of technologies related to production of organic electronic devices by a full-printing method that is low-cost and highly productive. As an electronic device, development of an organic transistor is underway, for example. This organic transistor is produced through many steps including a step of protecting an organic transistor with a protective film made of a resin, and a step of forming a pattern of an EL-emission section. This pattern is provided, for example, to cover a source electrode, a drain electrode, and an organic semiconductor layer or a polymer layer. The pattern is not present on an electrode, where the EL-emission section is formed.

Normally, the EL-emission section is formed using photolithography which is a technique to form a pattern constituted by an exposed site and an unexposed site by exposing a substrate surface to which a photosensitive substance (resist) has been applied to light in a pattern via a photomask or a reticle. In photolithography, the EL-emission section is opened by a dry-etching method or by wet-etching.

As a pattern formation material, a photoreactive polymeric material has been used. In an application method such as a full-printing method, after the material is dissolved in a solvent and applied in the form of an ink, and the solvent is removed by drying, a pattern is formed by insolubilizing the material in a solvent by subjecting the material to a photocrosslinking reaction. Therefore, the polymeric material used in the application method such as the full-printing method is demanded to have both the properties, that is, the material has excellent solubility in a solvent, and, after the solvent is removed, a photocrosslinking reaction of the material can be carried out at normal temperature and in a short exposure time.

Here, the following description will discuss a method for producing an organic electroluminescent device included in an organic electroluminescent display, an organic electroluminescent illumination device, and the like. First, on a substrate, a portion where a pattern is to be formed by applying the above polymeric material is subjected to a photocrosslinking reaction, and a portion that has not been subjected to the photocrosslinking reaction is removed. Thus, the residual portion becomes a pattern. Various functional layers are stacked in the portion (inside of the pattern) where the polymeric material has been removed. The technology of forming the functional layer using ink-like raw materials is promising. However, from the viewpoint of ink attachment to the inside of the pattern and prevention of ink leakage to the outside region beyond the portion where the polymeric material has not been removed (outside of the pattern), it is expected that the material constituting the pattern has liquid-repellency. In production of an organic electroluminescent device, an alkaline solution is often used, and thus solubility in an alkaline solution is demanded.

As such a material, Patent Document 1 lists a negative photosensitive resin composition that is highly photoreactive and can be patterned with an alkaline liquid, and can form a coating film having liquid repellency, and a photocured pattern produced from the composition. However, the resin in the composition does not have photocurability, and therefore the composition needs to be cured by heat at high temperature for a long time after patterning. Such high-temperature treatment for a long time causes a decrease in performance of an electronic device and a limitation in selection of a plastic substrate. Under the circumstances, it has been demanded to develop a fluorine-based material that is photocrosslinkable in order to prevent a decrease in performance of an electronic device.

As such a technique, there is a method for forming a pattern using a resin soluble in a fluorine-based solvent, as disclosed in Patent Document 2 and Non-Patent Document 1. However, there is a problem that the resin is not photocrosslinkable.

Examples of a resin that is photocrosslinkable include a resin disclosed in Non-Patent Document 2 in which an anthracene crosslinking group is used.

### Citation List

[Patent Document]

[Patent Document 1]
Japanese Patent No. 5932512
[Patent Document 2]

Japanese Patent No. 6281427

[Non-patent Document]

[Non-patent Document 1]
Appl. Phys. Express 7, 101602 (2014)
[Non-patent Document 2]
J Polym Sci A Polym Chem 53, 1252 (2015)

Summary of Invention

Technical Problem

However, the resin disclosed in Non-Patent Document 2 is less photocrosslinkable and requires high light exposure intensity. The resin is not soluble in an alkaline solution. Therefore, a resin having high photoreactivity and solubility in an alkaline solution is demanded.

The present invention is accomplished in view of the above problems, and its object is to provide a resin that has liquid-repellency, that is soluble in an alkaline solution, and that can become insoluble in a solvent by being photocrosslinked at low light exposure intensity.

Solution to Problem

As a result of diligent studies for solving the above problems, the inventors of the present invention have found that a resin having a specific structure solves the above problems, and have accomplished the present invention.

That is, a resin in accordance with an aspect of the present invention contains: a repeating unit that is represented by Formula (1) below including a photocrosslinkable group; and one or more units selected from the group consisting of a repeating unit that includes a fluorine atom, a repeating unit that includes an acidic functional group and a repeating unit that includes a hydrophilic functional group,

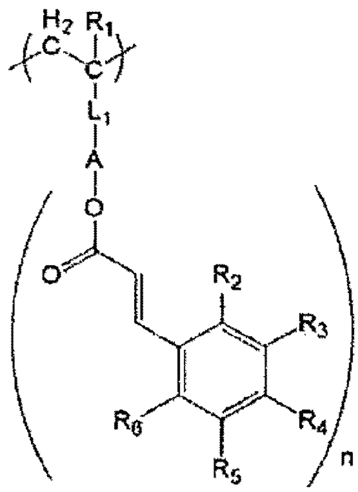

(1)

where $R_1$ represents a hydrogen atom or a methyl group, $L_1$ represents a single bond or a bivalent linking group, A represents a linking group having a valence of m, $R_2$, $R_3$, $R_4$, $R_5$, and $R_6$, which are identical to each other or different from each other, each represent one selected from the group consisting of a hydrogen atom, a halogen atom, linear alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group, m represents an integer of 3 or more, and n represents an integer of m-1.

Advantageous Effects of Invention

According to an aspect of the present invention, it is possible to obtain a resin that has liquid-repellency, that is soluble in an alkaline solution, and that becomes insoluble in a solvent by being photocrosslinked at low light exposure intensity. The resin can be used in pattern formation. By carrying out pattern formation using the resin, it is possible to prevent a decrease in performance of an obtained electronic device.

Brief Description of Drawings

Fig. 1 is a diagram illustrating a cross-sectional shape of an organic transistor.
Fig. 2 is a diagram illustrating a cross-sectional shape of an organic transistor which is an aspect of an electronic device of the present invention.

Description of Embodiments

The following description will discuss details of a resin which is an aspect of the present invention.
The resin of the present invention contains: a repeating unit that is represented by Formula (1) below; and one or more units selected from the group consisting of a repeating unit that includes a fluorine atom, a repeating unit that includes an acidic functional group and a repeating unit that includes a hydrophilic functional group.

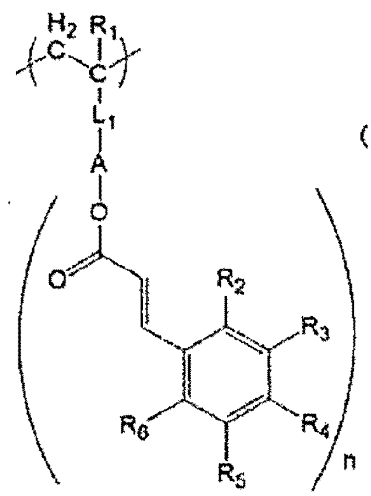

(1)

The above Formula (1) in the resin of the present invention includes a photocrosslinkable group. This makes it possible that the resin exhibits high photoreactivity, and that only a site irradiated with light in a film obtained by applying the resin is selectively insolubilized.
In Formula (1), $R_1$ represents a hydrogen atom or a methyl group.
In Formula (1), $L_1$ represents a single bond or a bivalent linking group.
The bivalent linking group at $L_1$ is preferably a bivalent linking group obtained by combining at least two groups selected from the group consisting of linear alkylene groups having 1 to 10 carbon atoms, branched alkylene groups having 3 to 10 carbon atoms, cyclic alkylene groups having 3 to 10 carbon atoms, arylene groups having 6 to 12 carbon atoms, an ether group (-O-), a carbonyl group (-C(=O)-), and an imino group (-NH-). This makes it possible to form a flat and non-cracked film.
Specific examples of the linear alkylene group having 1 to 10 carbon atoms include a methylene group, an ethylene group, a propylene group, a butylene group, a pentylene group, a hexylene group, a decylene group, and the like.
Specific examples of the branched alkylene group having 3 to 10 carbon atoms include a dimethylmethylene group, a methylethylene group, a 2,2-dimethylpropylene group, a 2-ethyl-2-methylpropylene group, and the like.
Specific examples of the cyclic alkylene group having 3 to 10 carbon atoms include a cyclopropylene group, a cyclobutylene group, a cyclopentylene group, a cyclohexylene group, a cyclooctylene group, a cyclodecylene group, an adamantane-diyl group, a norbornane-diyl group, an exo-tetrahydrodicyclopentadiene-diyl group, and the like. Among these, the cyclohexylene group is preferable.
Specific examples of the arylene group having 6 to 12 carbon atoms include a phenylene group, a xylylene group,

a biphenylene group, a naphthylene group, a 2,2'-methylenebisphenyl group, and the like. Among these, the phenylene group is preferable.

Among the above examples, the bivalent linking group is more preferably an ester bond (-C(=O)O-) obtained by combining a carbonyl group and an ether group, or a linking group obtained by combining a phenylene group and an ether group, and is further preferably (-C(=O)O-).

In Formula (1), A represents a linking group having a valence of m.

m represents an integer of 3 or more, and is preferably an integer of 3 to 5, more preferably an integer of 3 to 4, and further preferably 3.

In order to achieve better solubility of the obtained resin in an organic solvent and in a fluorine-based solvent, A may be a hydrocarbon group that has a valence of m, has 1 to 24 carbon atoms, and may contain a substituent.

Examples of the substituent which the hydrocarbon group A having a valence of m may have include an alkyl group, an alkoxy group, a halogen atom, a hydroxyl group, and the like.

For example, the alkyl group is preferably a linear, branched, or cyclic alkyl group having 1 to 18 carbon atoms, more preferably an alkyl group having 1 to 8 carbon atoms (e.g., a methyl group, an ethyl group, a propyl group, an isopropyl group, an n-butyl group, an isobutyl group, a sec-butyl group, a t-butyl group, a cyclohexyl group, or the like), further preferably an alkyl group having 1 to 4 carbon atoms, and particularly preferably a methyl group or an ethyl group.

Examples of the alkoxy group include alkoxy groups having 1 to 16 carbon atoms and having a linear or branched alkyl group, such as a methoxy group, an ethoxy group, an n-propoxy group, an n-butoxy group, an isobutoxy group, an n-pentyloxy group, an n-hexylixy group, an isohexyloxy group, an n-heptyloxy group, an n-octyloxy group, an n-nonyloxy group, an n-decyloxy group, an n-dodecyloxy group, an n-tetradecyloxy group, a 2-ethylhexyloxy group, a 3-ethylheptyloxy group, and a 2-hexyldecyloxy group, and is particularly preferably a group selected from the group consisting of a methoxy group, an ethoxy group, an n-propoxy group, an n-butoxy group, an isobutoxy group, an n-pentyloxy group, an n-hexyloxy group, an isohexyloxy group, an n-heptyloxy group, and an n-octyloxy group.

Examples of the halogen atom include a fluorine atom, a chlorine atom, a bromine atom, an iodine atom, and the like. Among these, the fluorine atom or the chlorine atom is preferable.

Among these, the hydrocarbon group A having a valence of m is preferably one linking group selected from the group consisting of Formulae (a-1) through (a-4) below.

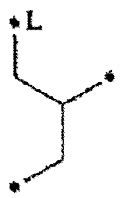
(a-1)

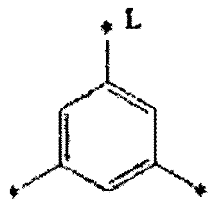
(a-2)

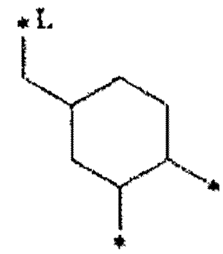
(a-3)

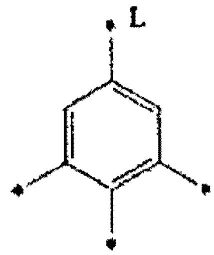
(a-4)

In Formulae (a-1) through (a-4), *L represents a linkage position with $L_1$ in the above Formula (1), and * at an end of a carbon atom represents a linkage position with an oxygen atom constituting an ester group in the above Formula (1).

For the reason of ease of reaction in monomer synthesis, the hydrocarbon group A having a valence of m is preferably one trivalent linking group selected from the group consisting of Formulae (a-1), (a-2), and (a-3), more preferably a trivalent linking group of Formula (a-1) or (a-2), and further preferably a trivalent linking group of Formula (a-1).

In Formula (1), $R_2$, $R_3$, $R_4$, $R_5$, and $R_6$, which are identical to each other or different from each other, each represent one selected from the group consisting of a hydrogen atom, a halogen atom, linear alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group.

Examples of the halogen atom include a fluorine atom, a chlorine atom, a bromine atom, an iodine atom, and the like. Among these, the fluorine atom or the chlorine atom is preferable.

The linear alkyl group having 1 to 20 carbon atoms is preferably a linear alkyl group having 1 to 6 carbon atoms, and specific examples thereof include a methyl group, an ethyl group, an n-propyl group, and the like. Among these, the methyl group or the ethyl group is preferable.

The branched alkyl group having 3 to 20 carbon atoms is preferably a branched alkyl group having 3 to 6 carbon atoms, and specific examples thereof include an isopropyl group, a tert-butyl group, and the like.

The cyclic alkyl group having 3 to 20 carbon atoms is preferably a cyclic alkyl group having 3 to 6 carbon atoms, and specific examples thereof include a cyclopropyl group, a cyclopentyl group, a cyclohexyl group, and the like. Among

these, the cyclohexyl group is preferable.

The linear alkyl halide group having 1 to 20 carbon atoms is preferably a linear fluoroalkyl group having 1 to 4 carbon atoms, and specific examples thereof include a trifluoromethyl group, a perfluoroethyl group, a perfluoropropyl group, a perfluorobutyl group, and the like. Among these, the trifluoromethyl group is preferable.

The alkoxy group having 1 to 20 carbon atoms is preferably an alkoxy group having 1 to 8 carbon atoms, and specific examples thereof include a methoxy group, an ethoxy group, an n-butoxy group, a methoxyethoxy group, and the like.

The aryl group having 6 to 20 carbon atoms is preferably an aryl group having 6 to 12 carbon atoms, and specific examples thereof include a phenyl group, an α-methylphenyl group, a naphthyl group, and the like. Among these, the phenyl group is preferable.

The aryloxy group having 6 to 20 carbon atoms is preferably an aryloxy group having 6 to 12 carbon atoms, and specific examples thereof include a phenyloxy group, a 2-naphthyloxy group, and the like. Among these, the phenyloxy group is preferable.

Examples of the amino group include a primary amino group ($-NH_2$); a secondary amino group such as a methylamino group; and a tertiary amino group such as a dimethylamino group, a diethylamino group, a dibenzylamino group, and a group having an atomic bonding which is a nitrogen atom of a nitrogen-containing heterocyclic compound (e.g., pyrrolidine, piperidine, piperazine, and the like).

In order to enhance solubility in a fluorine-based solvent, photocurability, and liquid-repellency of the resin, $R_2$, $R_3$, $R_4$, $R_5$, and $R_6$ are, independently, preferably one selected from the group consisting of a hydrogen atom, an alkyl group, a halogen atom, and a linear alkyl halide group having 1 to 20 carbon atoms, and further preferably a hydrogen atom.

Specific examples of the repeating unit (hereafter sometimes referred to as a repeating unit B) represented by Formula (1) including a photocrosslinkable group include repeating units B-1 through B-26 indicated below. Among these, B-1 through B-16 and the like are preferable, and B-1, B-2, B-13, and B-16 are particularly preferable. Note that, in the following Formulae, Me represents a methyl group, Et represents an ethyl group, and Pr represents an isopropyl group.

(B-1) (B-2) (B-3)

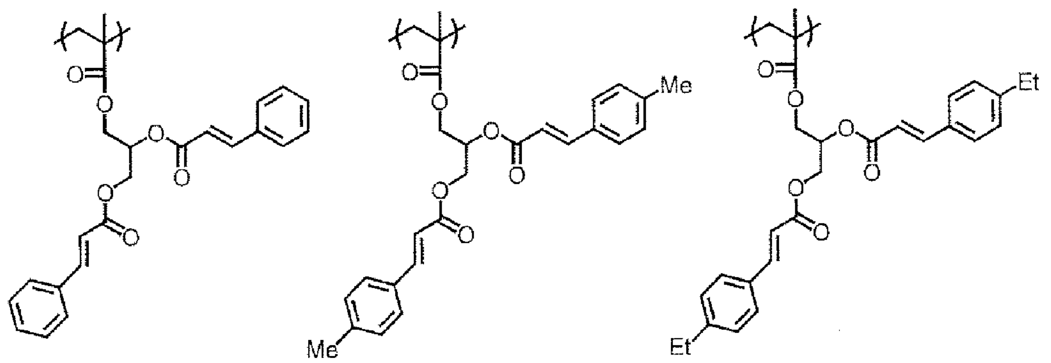

(B-4) (B-5) (B-6)

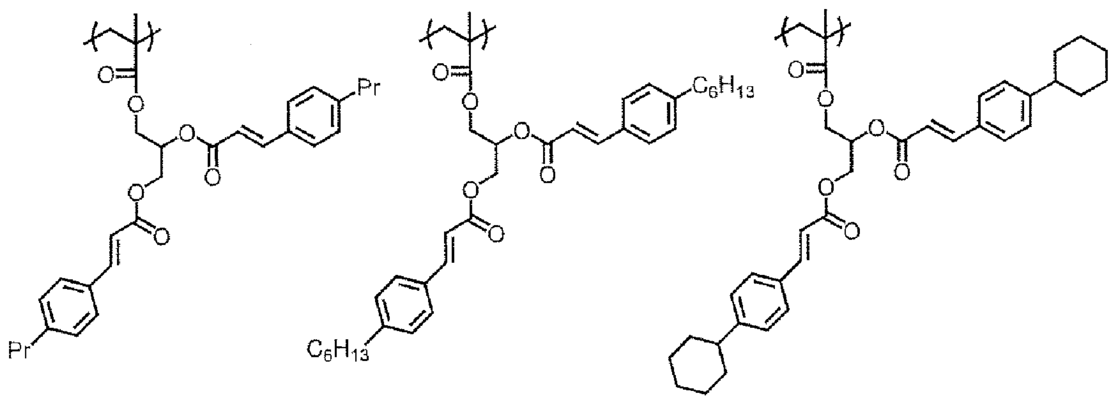

(B-7) (B-8) (B-9)

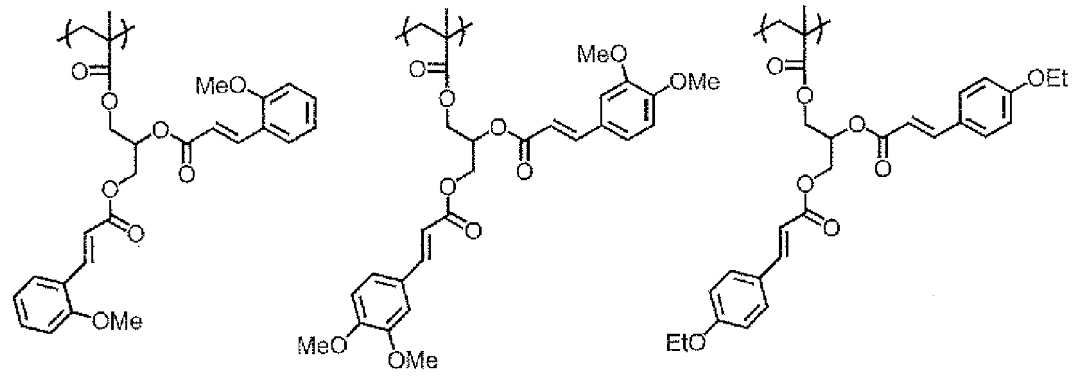

(B-10) (B-11) (B-12)

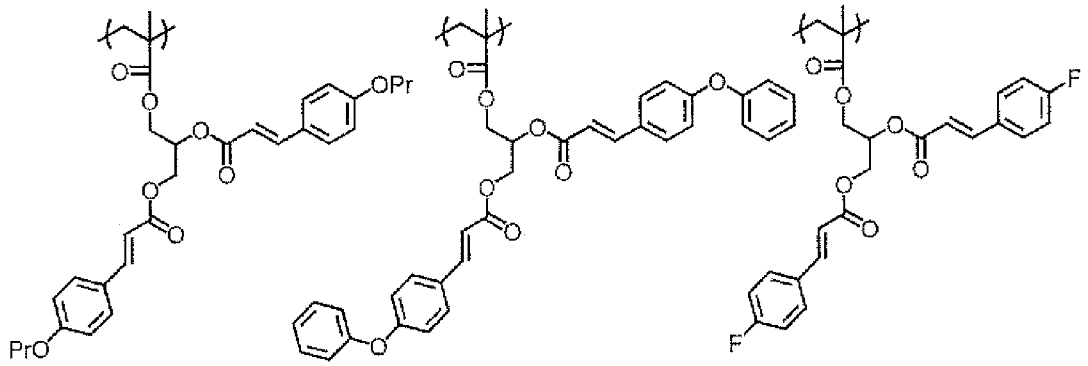

(B-13) (B-14) (B-15)

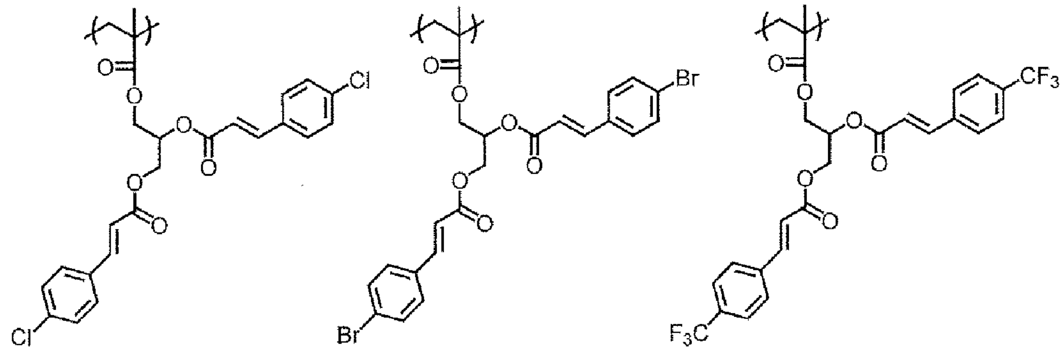

(B-16)

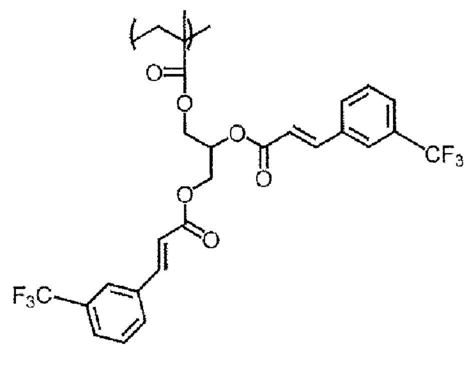

(B-17) (B-18) (B-19)

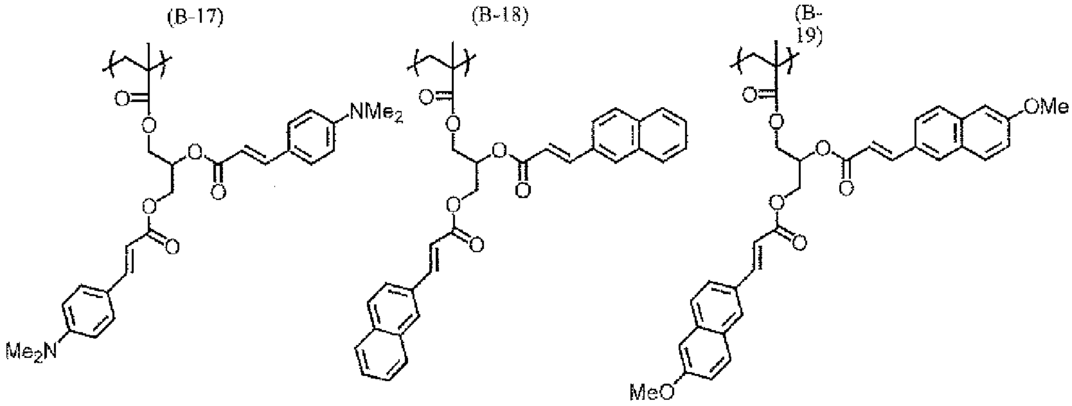

(B-20)

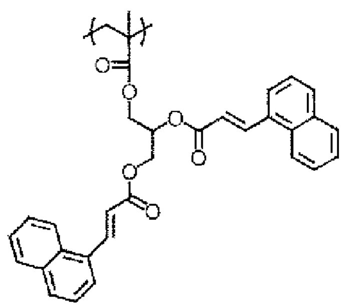

(B-21)

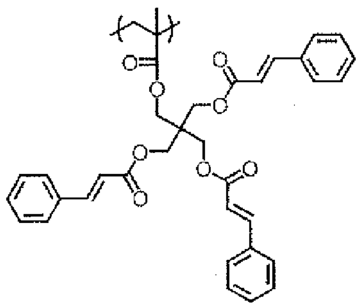

(B-22)

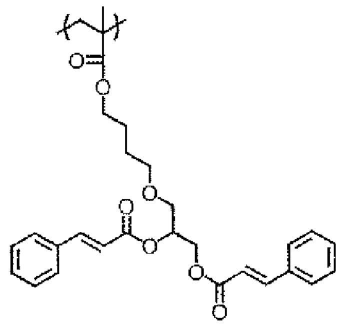

(B-23)

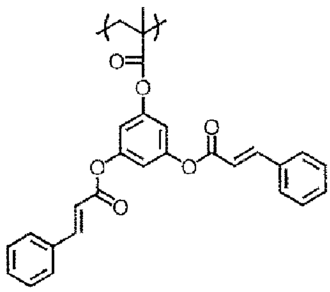

(B-24)

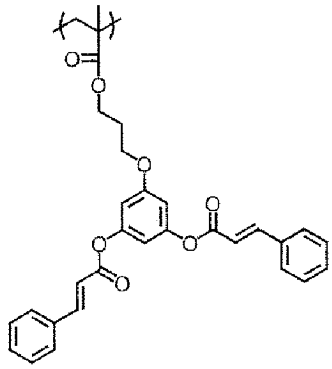

(B-25)

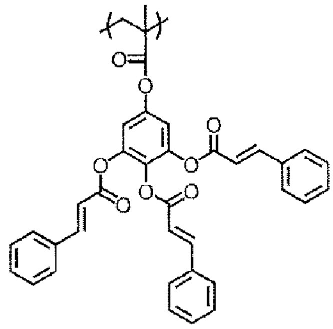

(B-26)

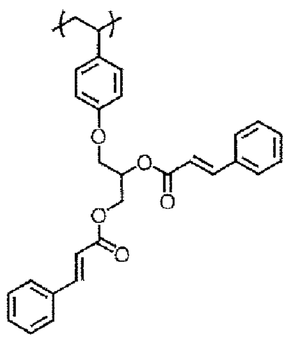

The resin of the present invention can contain one or more units selected from the group consisting of a repeating unit that includes a fluorine atom, a repeating unit that includes an acidic functional group and a repeating unit that includes a hydrophilic functional group.

From the viewpoint of liquid-repellency, the resin of the present invention can contain a repeating unit that

includes a fluorine atom, and this leads to easy film-separation for a film obtained by applying a composition containing the resin.

The repeating unit including a fluorine atom is preferably a repeating unit represented by Formula (2) below.

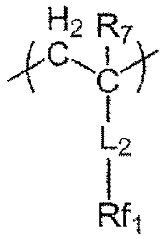

(2)

In Formula (2), $R_7$ represents a hydrogen atom or a methyl group.

In Formula (2), $L_2$ represents a single bond or a bivalent linking group.

The bivalent linking group in $L_2$ is preferably a bivalent linking group obtained by combining at least two groups selected from the group consisting of linear alkylene groups having 1 to 10 carbon atoms, branched alkylene groups having 3 to 20 carbon atoms, cyclic alkylene groups having 3 to 20 carbon atoms, arylene groups having 6 to 12 carbon atoms, an ether group (-O-), a carbonyl group (-C(=O)-), and an imino group (-NH-). This makes it possible to form a flat and non-cracked film.

Specific examples of the linear alkylene group having 1 to 10 carbon atoms include a methylene group, an ethylene group, a propylene group, a butylene group, a pentylene group, a hexylene group, a decylene group, and the like.

Specific examples of the branched alkylene group having 3 to 10 carbon atoms include a dimethylmethylene group, a methylethylene group, a 2,2-dimethylpropylene group, a 2-ethyl-2-methylpropylene group, and the like.

Specific examples of the cyclic alkylene group having 3 to 10 carbon atoms include a cyclopropylene group, a cyclobutylene group, a cyclopentylene group, a cyclohexylene group, a cyclooctylene group, a cyclodecylene group, an adamantane-diyl group, a norbornane-diyl group, an exo-tetrahydrodicyclopentadiene-diyl group, and the like. Among these, the cyclohexylene group is preferable.

Specific examples of the arylene group having 6 to 12 carbon atoms include a phenylene group, a xylylene group, a biphenylene group, a naphthylene group, a 2,2'-methylenebisphenyl group, and the like. Among these, the phenylene group is preferable.

Among the above examples, the bivalent linking group is more preferably an ester bond (-C(=O)O-) obtained by combining a carbonyl group and an ether group, or a linking group obtained by combining a phenylene group and an ether group, and is further preferably (-C(=O)O-).

In Formula (2), $Rf_1$ represents one selected from the group consisting of linear fluoroalkyl groups having 1 to 15 carbon atoms, branched fluoroalkyl groups having 3 to 15 carbon atoms, and cyclic fluoroalkyl groups having 3 to 15 carbon atoms.

In a case where $Rf_1$ is a fluoroalkyl group, the resin in accordance with an aspect of the present invention exhibits affinity with a fluorine-based solvent and liquid-repellency.

In a case where $Rf_1$ is a linear fluoroalkyl group, specific examples of $Rf_1$ include alkyl groups having 10 to 14 carbon atoms, a methyl group, an ethyl group, a propyl group, a butyl group, a pentyl group, a hexyl group, a heptyl group, an octyl group, and a nonyl group each of which is substituted by a fluorine atom. In a case where an element binding to $Rf_1$ in $L_2$ is oxygen, a position substituted by the fluorine atom in $Rf_1$ only needs to be on a carbon atom other than a carbon atom that is directly bound to oxygen in $L_2$.

In a case where $Rf_1$ is a linear fluoroalkyl group, $Rf_1$ is preferably a group represented by Formula (3) below.

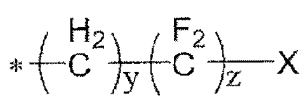

(3)

In Formula (3), * represents a linkage position with $L_2$ in Formula (2).

In Formula (3), X is a hydrogen atom or a fluorine atom.

In Formula (3), y is an integer of 1 to 4, and preferably 1 to 2.

In Formula (3), z is an integer of 1 to 14, preferably 2 to 10, and further preferably 4 to 8.

In a case where $Rf_1$ is a group represented by Formula (3), it becomes easier to synthesize a monomer that is used as a raw material for the repeating unit represented by Formula (2).

In a case where $Rf_1$ is a branched fluoroalkyl group, specific examples of $Rf_1$ include a 1,1,1,3,3,3-hexafluoroisopropyl group, a 1-(trifluoromethyl)-2,2,3,3,3-pentafluoropropyl group, a 1,1-bis(trifluoromethyl)-2,2,2-trifluoroethyl

group, and a 1,1-bis(trifluoromethyl)ethyl group.

In a case where $Rf_1$ is a cyclic fluoroalkyl group, specific examples of $Rf_1$ include a 1,2,2,3,3,4,4,5,5-nonafluorocyclopentane group and a 1,2,2,3,3,4,4,5,5,6,6-undecafluorocyclohexane group.

The repeating unit represented by the above Formula (2) is preferably a repeating unit represented by Formula (4) below.

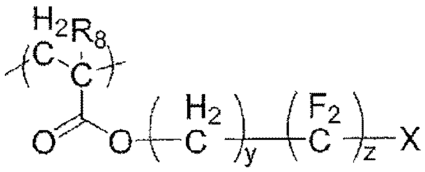

(4)

In Formula (4), $R_8$ represents either a hydrogen atom or a methyl group.

In Formula (4), X is a hydrogen atom or a fluorine atom.

In Formula (4), y is an integer of 1 to 4, and preferably 1 to 2.

In Formula (4), z is an integer of 1 to 14, preferably 2 to 10, and further preferably 4 to 8.

The resin in accordance with an aspect of the present invention may contain one repeating unit represented by the above Formula (2) and may contain two or more repeating units represented by Formula (2). For example, the resin may include both a repeating unit having, as $Rf_1$, a linear fluoroalkyl group described above and a repeating unit having, as $Rf_1$, a branched fluoroalkyl group described above. Alternatively, the resin may include two or more repeating units having linear fluoroalkyl groups differing in carbon number from each other. The resin in accordance with an aspect of the present invention preferably includes one repeating unit represented by Formula (2).

Specific examples of the repeating unit including a fluorine atom in the resin in accordance with an aspect of the present invention include one selected from the group consisting of repeating units represented by Formulae (C-1) through (C-33) below.

(C-1) (C-2) (C-3) (C-4)

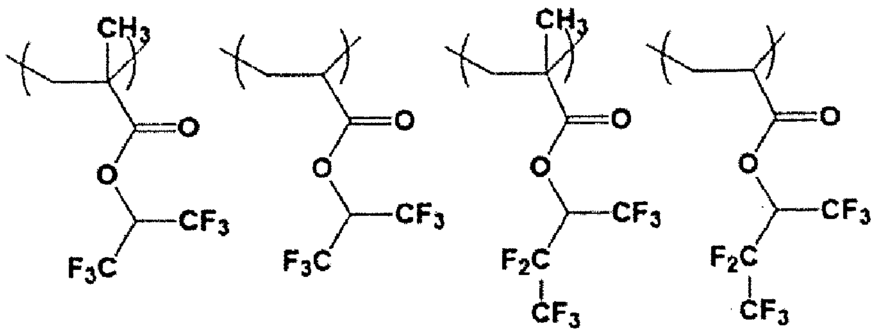

(C-5) (C-6) (C-7) (C-8)

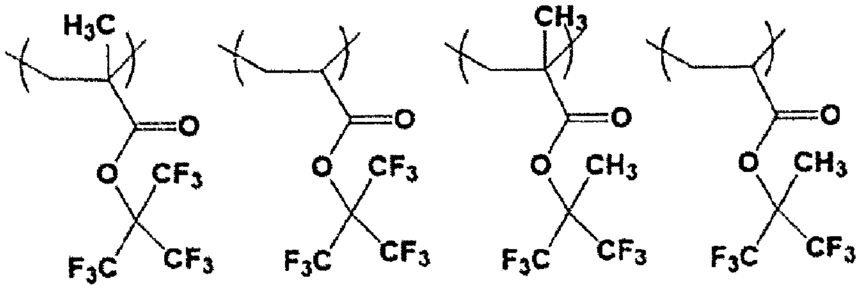

(C-9)

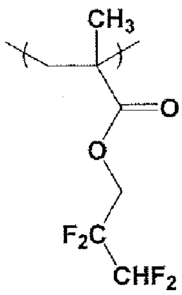

(C-10)

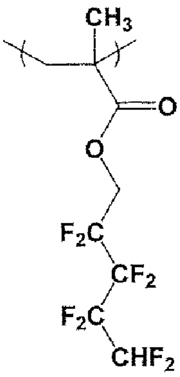

(C-11)

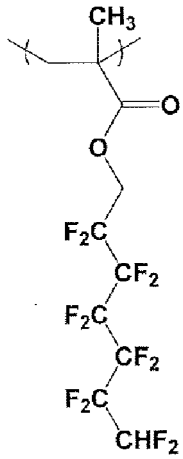

(C-12)

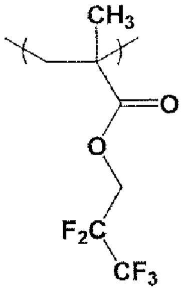

(C-13)

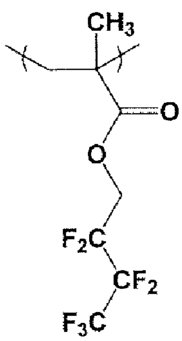

(C-14)

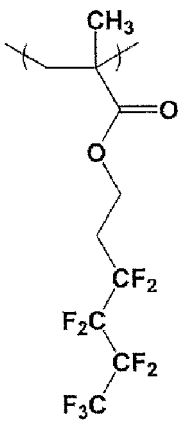

(C-15)

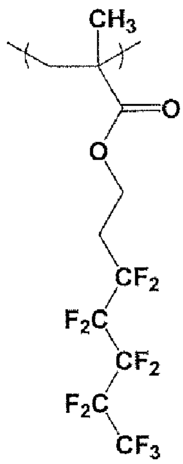

(C-16)

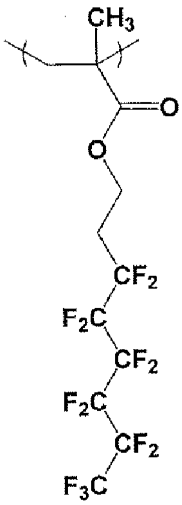

(C-17)

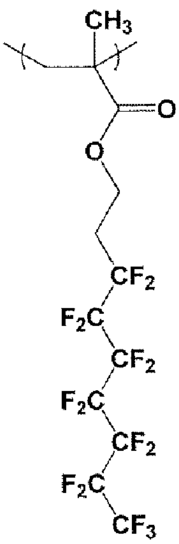

(C-18)

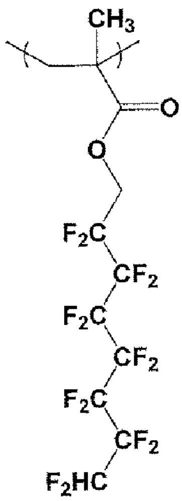

(C-19)

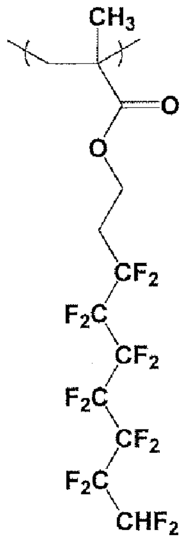

(C-20)

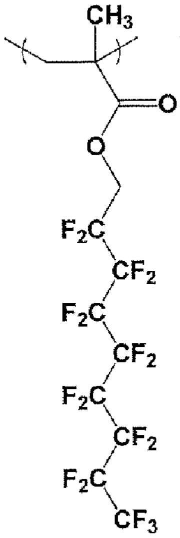

(C-21)

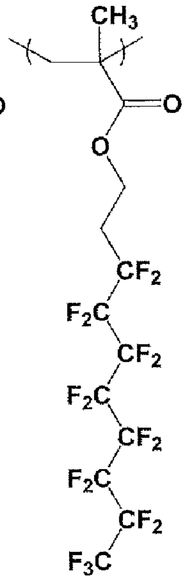

(C-22)

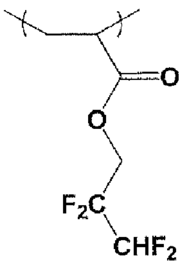

(C-23)

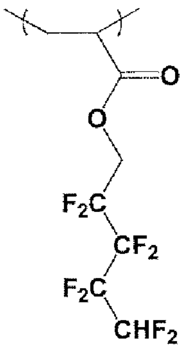

(C-24)

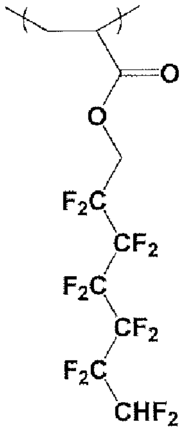

(C-25)

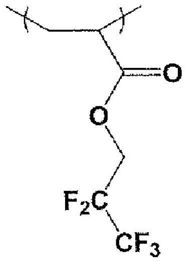

(C-26)

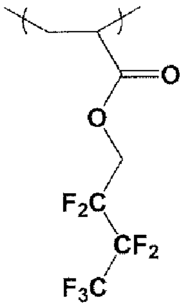

(C-27)

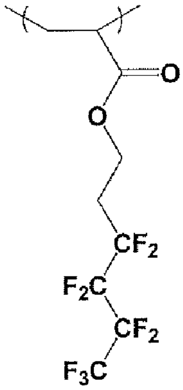

(C-28)

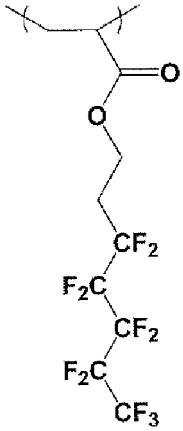

(C-29)

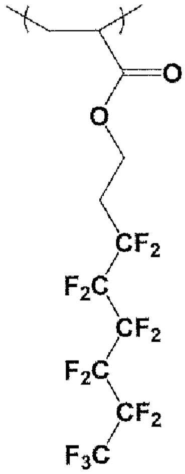

(C-30)

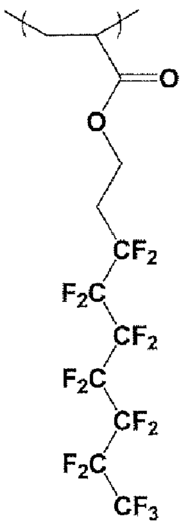

(C-31)

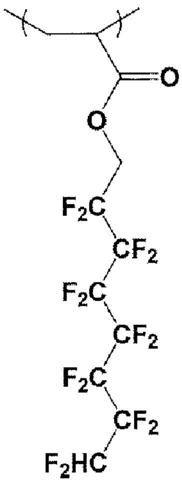

(C-32)

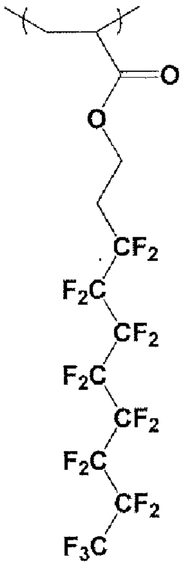

(C-33)

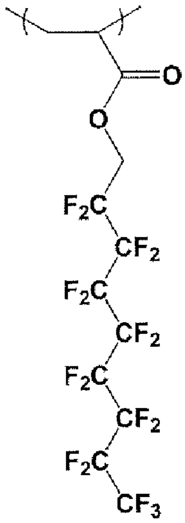

The repeating unit that includes a fluorine atom is preferably one selected from the group consisting of repeating units represented by the above Formulae (C-1) through (C-33), further preferably one selected from the group consisting of repeating units represented by Formulae (C-9) through (C-33), and particularly preferably one selected from the group consisting of repeating units represented by Formulae (C-14) through (C-21) or the group consisting of repeating units

represented by Formulae (C-27) through (C-33).

From the viewpoint of exhibition of solubility in an alkaline solution, the resin of the present invention can contain at least one of a repeating unit that includes an acidic functional group and a repeating unit that includes a hydrophilic functional group.

Specifically, at least one of the repeating unit that includes an acidic functional group and the repeating unit that includes a hydrophilic functional group is preferably a repeating unit that includes a functional group selected from a carboxyl group, a sulfo group, a phenolic hydroxyl group, an alcoholic hydroxyl group, an amide group, an amino group, and a cyano group, and is more preferably a repeating unit that includes a carboxyl group.

At least one of the repeating unit that includes an acidic functional group and the repeating unit that includes a hydrophilic functional group may be used alone or two or more of those may be used in combination. Note that, in a case where the repeating unit that includes an acidic functional group and the repeating unit that includes a hydrophilic functional group are identical to each other in terms of a chemical structural formula thereof, those two repeating units are counted as one type. A repeating unit used may be a repeating unit that includes an acidic and hydrophilic functional group or a repeating unit that includes both (i) a functional group which is acidic and is not hydrophilic and (ii) a functional group which is hydrophilic and is not acidic.

At least one of the repeating unit that includes an acidic functional group and the repeating unit that includes a hydrophilic functional group is preferably a repeating unit represented by Formula (a) below.

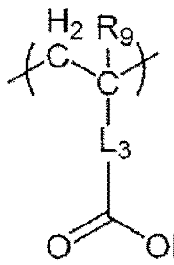

(a)

where $R_9$ represents a hydrogen atom or a methyl group, and $L_3$ represents a single bond or a bivalent linking group.

The bivalent linking group at $L_3$ is preferably a bivalent linking group obtained by combining at least two groups selected from the group consisting of linear alkylene groups having 1 to 10 carbon atoms, branched alkylene groups having 3 to 10 carbon atoms, cyclic alkylene groups having 3 to 10 carbon atoms, arylene groups having 6 to 12 carbon atoms, an ether group (-O-), a carbonyl group (-C(=O)-), and an imino group (-NH-). This makes it possible to form a flat and non-cracked film.

Specific examples of the linear alkylene group having 1 to 10 carbon atoms include a methylene group, an ethylene group, a propylene group, a butylene group, a pentylene group, a hexylene group, a decylene group, and the like.

Specific examples of the branched alkylene group having 3 to 10 carbon atoms include a dimethylmethylene group, a methylethylene group, a 2,2-dimethylpropylene group, a 2-ethyl-2-methylpropylene group, and the like.

Specific examples of the cyclic alkylene group having 3 to 10 carbon atoms include a cyclopropylene group, a cyclobutylene group, a cyclopentylene group, a cyclohexylene group, a cyclooctylene group, a cyclodecylene group, an adamantane-diyl group, a norbornane-diyl group, an exo-tetrahydrodicyclopentadiene-diyl group, and the like. Among these, the cyclohexylene group is preferable.

Specific examples of the arylene group having 6 to 12 carbon atoms include a phenylene group, a xylylene group, a biphenylene group, a naphthylene group, a 2,2'-methylenebisphenyl group, and the like. Among these, the phenylene group is preferable.

Among the above examples, the bivalent linking group is more preferably an arylene group having 6 to 12 carbon atoms, and is further preferably a phenylene group.

$L_3$ is more preferably a single bond or an arylene group having 6 to 12 carbon atoms, and is further preferably a single bond or a phenylene group.

Specific examples of the repeating unit that includes an acidic functional group and the repeating unit that includes a hydrophilic functional group in the resin in accordance with an aspect of the present invention include one selected from the group consisting of repeating units represented by Formulae (D-1) through (D-23) below. Among those, (D-1), (D-2), and (D-19) through (D-23) which satisfy Formula (a) are preferable, (D-1), (D-2), and (D-20) through (D-22) are more preferable, and (D-1) and (D-22) are more preferable.

In formulae below, $R_9$ is a hydrogen atom or a methyl group.

(D-1)

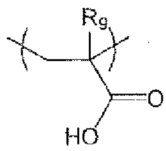

(D-2)

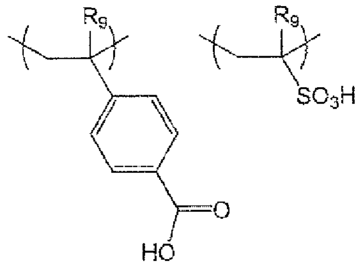

(D-3)

(D-4)

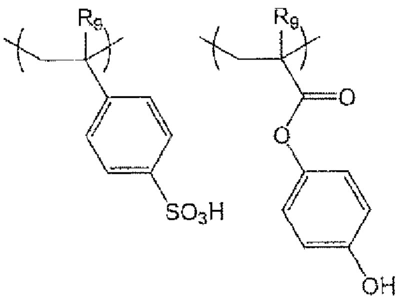

(D-5)

(D-6)

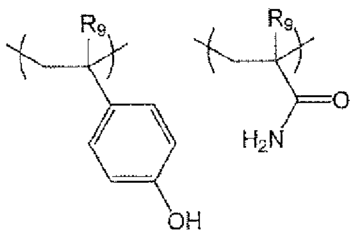

(D-7)

(D-8)

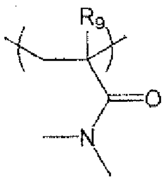

(D-9)

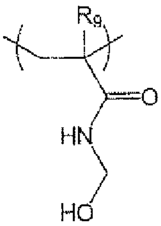

(D-10)

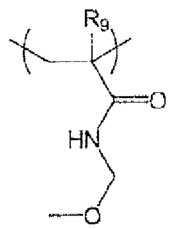

(D-11)

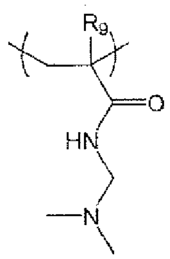

(D-12)

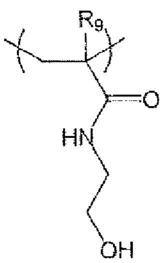

(D-13)

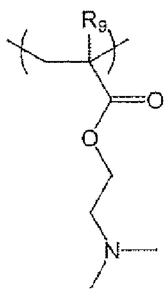

(D-14)

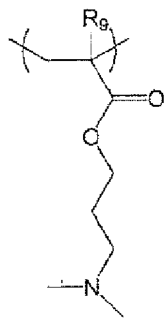

(D-15)

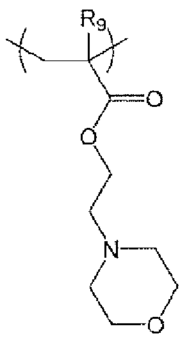

(D-16)

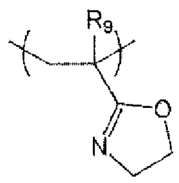

(D-17)

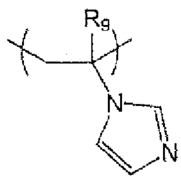

(D-18)

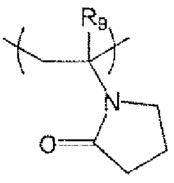

(D-19)

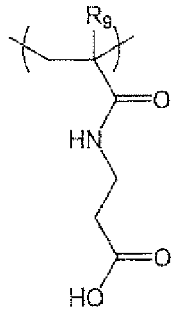

(D-20)

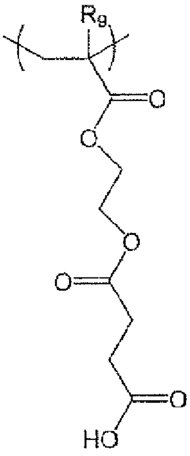

(D-21)

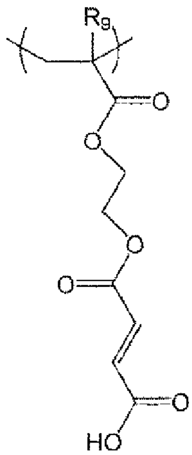

(D-22)

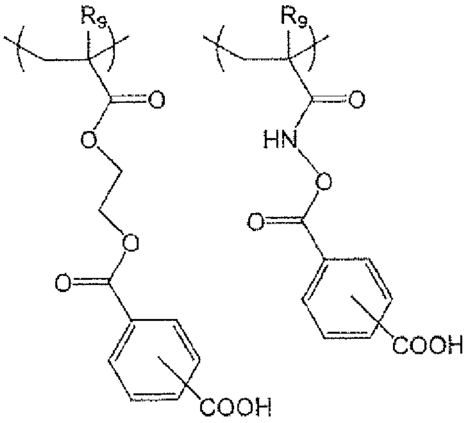

(D-23)

From the viewpoint of enhancement of solubility in an alkaline solution and more efficient photocuring, the resin in accordance with an aspect of the present invention contains the repeating unit represented by the above Formula (1) in an amount of preferably 5 mol% or more and 50 mol% or less, and preferably 5 mol% or more and 40 mol% or less.

The resin in accordance with an aspect of the present invention preferably contains a repeating unit that includes a fluorine atom in an amount of preferably 5 mol% or more and 50 mol% or less, preferably 5 mol% or more and 40 mol% or less, and preferably 5 mol% or more and 30 mol% or less.

The resin in accordance with an aspect of the present invention preferably includes a repeating unit that includes an acidic functional group in an amount of preferably 20 mol% or more and 90 mol% or less, preferably 30 mol% or more and 90 mol% or less, and preferably 30 mol% or more and 80 mol% or less.

The resin in accordance with an aspect of the present invention preferably includes a repeating unit that includes a hydrophilic functional group in an amount of preferably 20 mol% or more and 90 mol% or less, preferably 30 mol% or more and 90 mol% or less, and preferably 30 mol% or more and 80 mol% or less.

The resin in accordance with an aspect of the present invention may include another monomer repeating unit within a range that does not deviate from the object of the present invention. Examples of the another monomer repeating unit include olefin residue units such as an ethylene residue unit, a propylene residue unit, and a 1-butene residue unit; aromatic vinyl hydrocarbon residue units such as a styrene residue unit and an $\alpha$-methylstyrene residue unit; carboxylic acid vinyl ester residue units such as a vinyl acetate residue unit, a vinyl propionate residue unit, and a vinyl pivalate residue unit; vinyl ether residue units such as a methyl vinyl ether residue unit, an ethyl vinyl ether residue unit, and a butyl vinyl ether residue unit; N-substituted maleimide residue units such as an N-methylmaleimide residue unit, an N-cyclohexylmaleimide residue unit, and an N-phenylmaleimide residue unit; an acrylonitrile residue unit; a methacrylonitrile residue unit; a silicone residue unit; and the like.

In the resin of the present invention, a molecular weight thereof is not particularly limited, and can be, for example, 2,000 to 10,000,000 (g/mol). From the viewpoint of solution viscosity and mechanical strength of an obtained resin, the molecular weight is preferably 10,000 to 1,000,000 (g/mol).

A synthesis method of the resin of the present invention is not particularly limited, and the resin can be synthesized by, for example, mixing a monomer forming the repeating unit represented by the above Formula (1), a monomer forming the foregoing repeating unit that includes a fluorine atom, a monomer forming the foregoing repeating

unit that includes an acidic functional group, a monomer forming the foregoing repeating unit that includes a hydrophilic functional group, and a monomer forming any other repeating unit, and polymerizing the resultant mixture with a radical polymerization initiator in an organic solvent.

The resin of the present invention is preferably soluble in an alkaline solution.

The following description will discuss the alkaline solution.

The above alkaline solution is preferably an aqueous solution of an alkali including at least one of inorganic alkalis, primary amines, secondary amines, tertiary amines, alcoholamines, quaternary ammonium salts, and cyclic amines.

Examples of the inorganic alkalis include sodium hydroxide, potassium hydroxide, sodium carbonate, sodium silicate, sodium metasilicate, ammonia water, and the like.

Examples of the primary amines include ethylamine, n-propylamine, and the like.

Examples of the secondary amines include diethylamine, di-n-butylamine, and the like.

Examples of the tertiary amines include triethylamine, methyldiethylamine, and the like.

Examples of the alcoholamines include dimethylethanolamine, triethanolamine, and the like.

Examples of the quaternary ammonium salts include tetramethylammonium hydroxide, tetraethylammonium hydroxide, choline, and the like.

Examples of the cyclic amines include pyrrole, piperidine, and the like.

Among these, the alkaline solution is preferably inorganic alkalis, tertiary amines, alcoholamines, quaternary ammonium salts, and the like, and particularly preferably quaternary ammonium salts.

A hydrogen ion concentration index of the above alkaline solution is preferably a pH of 8 or more, more preferably a pH of 10 or more, and more preferably a pH of 12 or more.

The following description will discuss a composition which is one aspect of the present invention.

The composition in accordance with an aspect of the present invention includes: at least one of an organic solvent and a fluorine-based solvent; and a resin.

The above fluorine-based solvent only needs to be one that dissolves the resin of the present invention. By using the fluorine-based solvent as a solvent to dissolve the resin, it is possible to minimize damage to device constituent members mainly constituted by organic matter during production of an electronic device by a full-printing method, and this allows the electronic device to sufficiently provide its performance.

In a fluorine-based compound constituting the fluorine-based solvent, a fluorine atom content is 50% by mass or more and 70% by mass or less, more preferably 55% by mass or more and 70% by mass or less, relative to a total mass of the fluorine-based compound. If the fluorine atom content exceeds 70% by mass, the foregoing resin may not be dissolved sufficiently. If the fluorine atom content is less than 50% by mass, a surface of an organic semiconductor film may be dissolved or swollen when application or printing onto the organic semiconductor film is carried out.

As the fluorine-based solvent contained in the composition of the present invention, fluorine-containing hydrocarbon, fluorine-containing ether, or fluorine-containing alcohol indicated below can be preferably used, and the fluorine-containing hydrocarbon or the fluorine-containing ether can be more preferably used.

The fluorine-containing hydrocarbon has a low ozone depleting potential and is preferably used as the fluorine-based solvent contained in the composition of the present invention. In particular, fluorine-containing hydrocarbon which has 4 to 8 carbon atoms, which is linear, branched, or cyclic hydrocarbon, and in which at least one hydrogen atom is substituted by a fluorine atom, can be easily applied and is preferable.

Specific examples of such a fluorine-containing hydrocarbon include one in which at least one hydrogen atom in butane, pentane, hexane, heptane, octane, cyclopentane, cyclohexane, or benzene has been substituted by a fluorine atom. Specific examples of such a fluorine-containing hydrocarbon include 1,1,1,3,3-pentafluorobutane, 1,1,1,2,2,3,3,4,4,5,5,6,6-tridecafluorohexane, 2H,3H-decafluoropentane, 1,1,1,2,2,3,3,4,4,5,5,6,6-tridecafluorooctane, hexafluorocyclopentane, 1,1,2,2,3,3,4-heptafluorocyclopentane, and hexafluorobenzene.

The fluorine-containing hydrocarbon has a boiling point of preferably 200°C or less, and further preferably 180°C or less. In a case where the boiling point of the fluorine-containing hydrocarbon is not more than 200°C, it is easy to evaporate and remove the fluorine-containing hydrocarbon by heating.

Among the above fluorine-containing hydrocarbons, examples of fluorine-containing hydrocarbon having a particularly preferable boiling point are as follows.

Examples of such a fluorine-containing hydrocarbon include 2H,3H-decafluoropentane, 1,1,2,2,3,3,4-heptafluorocyclopentane, 1,1,2,2,3,3,4,4,5,5,6,6-tridecafluorooctane, 1,1,1,2,2,3,3,4,4,5,5,6,6-tridecafluorohexane, and hexafluorobenzene.

In view of low ozone depleting potential, fluorine-containing ether can be used as the fluorine-based solvent. In particular, the fluorine-containing ether has a boiling point of preferably 200°C or less, and further preferably 180°C or less. In a case where the boiling point of the fluorine-containing ether is not more than 200°C, it is easy to evaporate and remove the fluorine-containing ether from a resin film by heating.

Preferable examples of the fluorine-containing ether include 1,1,2,3,3,3-hexafluoro-1-(2,2,2-trifluoroethoxy)propane, 1,1,2,3,3,3-hexafluoro-1-(2,2,3,3,3-pentafluoropropoxy)propane, 1,1,2,3,3,3-hexafluoro-1-(2,2,3,3-tetrafluoropropoxy)propane, 2,2,3,3,3-pentafluoro-1-(1,1,2,2-tetrafluoroethoxy)propane, 1,1,1,2,2,3,3-heptafluoro-3-methoxypropane, methyl perfluorobutyl ether, and ethyl nonafluorobutyl ether.

Examples of a fluorine-containing ether having a preferable boiling point include ethyl nonafluorobutyl ether, methyl perfluorobutyl ether, ethyl nonafluorobutyl ether, 1,1,1,2,3,4,4,5,5,5-decafluoro-3-methoxy-2-(trifluoromethyl) pentane, 2-(trifluoromethyl)-3-ethoxydodecafluorohexane, (1,1,1,2,3,3-hexafluoropropoxy)pentane, 1,1,2,2-tetrafluoroethyl 2,2,2-trifluoroethylether, and methoxyperfluoroheptene.

As the fluorine-based solvent, fluorine-containing alcohol can be used. The fluorine-containing alcohol used has a boiling point of preferably 200°C or less, and further preferably 180°C or less. In a case where the boiling point of the fluorine-containing alcohol is not more than 200°C, it is easy to evaporate and remove the fluorine-containing alcohol by heating.

Preferable examples of the fluorine-containing alcohol include 1H,1H-trifluoroethanol, 1H1H-pentafluoropropanol, 1H,1H-heptafluorobutanol, 2-(perfluorobutyl)ethanol, 3-(perfluorobutyl)propanol, 2-(perfluorohexyl)ethanol, 3-(perfluorohexyl)propanol, 1H,1H,3H-tetrafluoropropanol, 1H,1H,5H-octafluoropentanol, 1H,1H,7H-dodecafluoroheptanol, 2H-hexafluoro-2-propanol, and 1H,1H,3H-hexafluorobutanol.

Furthermore, in order to enhance solubility of the resin, the composition in accordance with an aspect of the present invention may contain two or more fluorine-based solvents.

The organic solvent used in the composition of the present invention refers to an organic solvent which is not a fluorine-based solvent. The organic solvent is not particularly limited, provided that the resin of the present invention is dissolved in the organic solvent, and examples of the organic solvent include hexane, heptane, octane, decane, dodecane, tetradecane, hexadecane, decalin, indan, 1-methylnaphthalene, 2-ethylnaphthalene, 1,4-dimethylnaphthalene, a dimethylnaphthalene isomer mixture, toluene, xylene, ethylbenzene, 1,2,4-trimethylbenzene, mesitylene, isopropyl benzene, pentylbenzene, hexylbenzene, tetralin, octylbenzene, cyclohexylbenzene, 1,2-dichlorobenzene, 1,3-dichlorobenzene, 1,4-dichlorobenzene, trichlorobenzene, 1,2-dimethoxybenzene, 1,3-dimethoxybenzene, γ-butyrolactone, 1,3-butylene glycol, ethylene glycol, benzyl alcohol, glycerin, cyclohexanol acetate, 3-methoxy butyl acetate, ethylene glycol monomethyl ether acetate, ethylene glycol monobutyl ether acetate, propylene glycol monomethyl ether acetate, anisole, cyclohexanone, mesitylene, 3-methoxy butyl acetate, cyclohexanol acetate, dipropylene glycol diacetate, dipropylene glycol methyl ether acetate, diethylene glycol monobutyl ether acetate, diethylene glycol monoethyl ether acetate, 1,6-hexanediol diacetate, 1,3-butylene glycol diacetate, 1,4-butanediol diacetate, ethyl acetate, phenyl acetate, dipropylene glycol dimethyl ether, dipropylene glycol methyl-N-propyl ether, tetradecahydrophenanthrene, 1,2,3,4,5,6,7,8-octahydrophenanthrene, decahydro-2-naphthol, 1,2,3,4-tetrahydro-1-naphthol, α-terpineol, isophoronetriacetindecahydro-2-naphthol, dipropylene glycol dimethyl ether, 2,6-dimethylanisole, 1,2-dimethylanisole, 2,3-dimethylanisole, 3,4-dimethylanisole, 1-benzothiophene, 3-methylbenzothiophene, 1,2-dichloroethane, 1,1,2,2-tetrachloroethane, chloroform, dichloromethane, tetrahydrofuran, 1,2-dimethoxyethane, dioxane, cyclohexanone, acetone, methyl ethyl ketone, diethyl ketone, diisopropyl ketone, acetophenone, N,N-dimethylformamide, N-methyl-2-pyrolidone, limonene, and the like. In order to obtain a film having a preferable property, an organic solvent having high solvency to dissolve a resin is suitable. Such an organic solvent is preferably xylene or propylene glycol monomethyl ether acetate. It is possible to use a mixed solvent in which two or more of the above solvents are mixed at an appropriate ratio.

The composition containing the resin in accordance with an aspect of the present invention and at least one of an organic solvent and a fluorine-based solvent contains the resin in an amount of preferably 1 wt% or more and 50 wt% or less, and contains the solvent in an amount of preferably 50 wt% or more and 99 wt% or less.

The composition in accordance with an aspect of the present invention may contain a photosensitizer. The photosensitizer only needs to facilitate a cross-linking reaction of the photocrosslinkable group.

Examples of the photosensitizer include acyloins such as benzoin, benzoin methyl ether, benzoin isopropyl ether, and benzoin isobutyl ether; carbonyls such as anthraquinone, 2-methylanthraquinone, 1,2-benzanthraquinone, 1-chloroanthraquinone, and cyclohexanone; diketones such as diacetyl and benzyl; organic sulfides such as diphenyl monosulfide, diphenyl disulfide, and tetramethylthiuram disulfide; phenones such as acetophenone, benzophenone, 4,4'-bis(dimethylamino)benzophenone, 4,4'-bis(diethylamino)benzophenone, o-methoxybenzophenone, and 2,4,6-trimethoxybenzophenone; sulfonyl halides such as p-toluenesulfonyl chloride, I-naphthalenesulfonyl chloride, 1,3-benzenesulfonyl chloride, 2,4-dinitrobenzenesulfonyl bromide, and p-acetamidebenzenesulfonyl chloride; aromatic nitro compounds such as 5-nitrofluorene, 5-nitroacenaphthene, N-acetyl-4-nitro-1-naphthylamine, and picramide; coumarins such as 7-diethylamino-3-thenoylcoumarin and 3,3'-carbonylbis(7-diethylaminocoumarin); halogenated hydrocarbons such as carbon tetrachloride, hexabromoethane, and 1,1,2,2-tetrabromoethane; nitrogen derivatives such as diazomethane, abbisisobutyronitrile, hydrazine, and trimethylbenzylammonium chloride; pigments such as ethionine, thionin, and methylene blue; and the like. By adding the photosensitizer, it is possible to crosslink (insolubilize) the resin in accordance with an aspect of the present invention at lower light exposure intensity. It is possible to use two or more of the sensitizers in combination, if necessary.

The composition containing the resin in accordance with an aspect of the present invention, a photosensitizer,

and at least one of an organic solvent and a fluorine-based solvent contains the resin in an amount of preferably 1 wt% or more and 50 wt% or less, and contains the solvent in an amount of preferably 50 wt% or more and 99 wt% or less, and contains the photosensitizer in an amount of preferably 0.001 wt% or more and 5 wt% or less.

The following description will discuss a pattern which is one aspect of the present invention.

The resin of the present invention can be used to form a pattern. More specifically, the resin of the present invention or a composition thereof is used to obtain a photocrosslinked product, and a pattern is formed. Here, a cured product which is formed by photocrosslinking of the resin of the present invention or a composition thereof, that is, a photocrosslinked product, is also an aspect of the present invention.

First, by a known film formation method, a coating film of the resin is formed on a surface of a substrate. Examples of the substrate include: various glass plates; polyesters such as polyethylene terephthalate; polyolefins such as polypropylene and polyethylene; thermoplastic plastic sheets such as polycarbonate, polymethyl methacrylate, polysulfone, and polyimide; epoxy resins; polyester resins; thermosetting plastic sheets of, for example, a poly(meth)acrylic resin; and the like.

Examples of a method for forming a coating film include spin coating, drop casting, dip coating, doctor blade coating, pad printing, squeegee coating, roller coating, rod bar coating, air knife coating, wire bar coating, flow coating, gravure printing, flexo printing, super flexo printing, screen printing, inkjet printing, letterpress reverse printing, reverse offset printing, adhesion contrast printing, and the like.

Next, the coating film is dried. By drying, the solvent is volatilized, and thus a non-adhesive coating film is obtained. Drying conditions vary depending on a boiling point and a mixing ratio of a solvent used. Preferably, the drying conditions can be wide ranges of approximately 50°C to 150°C and approximately 10 seconds to 2,000 seconds.

At the time of film formation, when a printing technique is used to form a coating film having a predetermined shape, i.e., a shape identical to an intended pattern, the coating film having the predetermined shape is photocrosslinked by light exposure to obtain a photocrosslinked product, and the photocrosslinked product is then fixed to form a pattern.

On the other hand, in a case where a coating film having a predetermined shape is not formed at the time of film formation, a pattern can be formed from the coating film using a photolithographic technique. In a case where the photolithographic technique is used, a dried coating film is first exposed to light via a mask having a predetermined shape, that is, a shape that can form an intended pattern, and the coating film is thus photocrosslinked.

In curing the resin of the present invention by photocrosslinking, radial rays such as ultraviolet rays or visible light are used. For example, ultraviolet rays having a wavelength of 245 nm to 435 nm are used. A radiation quantity may be changed as appropriate according to a composition of the resin, and can be, for example, 10 $mJ/cm^2$ to 5,000 $mJ/cm^2$. From the viewpoint of preventing a decrease in degree of crosslinking and enhancing economy by shortening a process time, the radiation quantity is preferably 100 $mJ/cm^2$ to 4,000 $mJ/cm^2$. Specific examples of a light irradiator or a light source include a sterilization lamp, an ultraviolet fluorescent light, a carbon arc, a xenon lamp, a high-pressure mercury lamp for copying, a medium-pressure or high-pressure mercury lamp, an ultra-high-pressure mercury lamp, an electrodeless lamp, a metal halide lamp, and the like.

Ultraviolet radiation is usually carried out in the atmosphere. However, ultraviolet radiation can also be carried out in an inert gas or under a predetermined rate of inert gas flow, if necessary. The above photosensitizer may be, if necessary, added to facilitate a photocrosslinking reaction. Then, developing is carried out with a developer, and an unexposed portion is removed. The developer is not particularly limited, provided that the developer is an alkaline solution or an organic solvent in which an uncured resin is dissolved. Examples of the developer include the foregoing alkaline solution; aromatic solvents such as benzene, toluene, and xylene; ether-based solvents such as dioxane, diethyl ether, tetrahydrofuran, and diethylene glycol dimethyl ether; ketone-based solvents such as acetone and methyl ethyl ketone; ester-based solvents such as ethyl acetate, butyl acetate, isopropyl acetate, and propylene glycol monomethyl ether acetate; fluorine-based solvents such as 2H,3H-decafluoropentane, 1,1,2,2,3,3,4-heptafluorocyclopentane, 1,1,2,2-tetrafluoroethyl-2,2,2-trifluoroethylether, hexafluorobenzene, 2,2,3,3-tetrafluoro-1-propanol, 2,2,3,3,4,4,5,5-octafluoro-1-pentanol, 1H,1H,7H-dodecafluoro-1-heptanol, and 2,2,3,3,4,4,4-heptafluoro-1-butanol; and the like.

The developing time is preferably 30 to 300 seconds. The developing method can be any one of a puddle method, a dipping method, and the like. After developing, cleaning is carried out with a solvent, and the solvent on the substrate is removed by air-drying with compressed air or compressed nitrogen. Subsequently, a pattern is formed by carrying out a heat treatment for 5 to 90 minutes with a heating device such as a hot plate or an oven, preferably at 40°C to 150°C.

After undergoing the above photolithography process to form a pixel pattern, dirt on the substrate surface in pixels may be removed. For example, it is possible to clean the substrate surface by short-wavelength ultraviolet radiation such as a low-pressure mercury lamp or excimer UV, a photo-ashing treatment, or the like. The photo-ashing treatment is a treatment in which short-wavelength ultraviolet radiation is carried out in the presence of an ozone gas. The above short-wavelength ultraviolet ray is light having a main peak at a wavelength of 100 nm to 300 nm.

In a case where liquid-repellency has decreased after removing dirt on the substrate surface in the above pixels, it is possible to recover liquid-repellency with a heat treatment or the like.

Thus, the resin of the present invention itself is soluble in an alkaline solution or an organic solvent. When the

resin is irradiated with light, the photocrosslinkable group present in the side chain is crosslinked and cured, and the resin becomes insoluble in the solvent used. Taking advantage of this property, the resin of the present invention can be used as a negative-type resist in which a part that has not been irradiated with light is removed by an alkaline solution or an organic solvent when the resin is crosslinked by irradiation with light.

After patterning with use of the resin of the present invention, a portion (outside of the pattern) where the resin has been crosslinked and remains has a contact angle with respect to the ink at preferably 40° or more and more preferably 50° or more, in order to avoid spread of wetting of the ink for forming a functional layer.

The resin of the present invention can be formed into a protective film in a manner similar to patterning such as a coating film formation method, photocrosslinking, and developing.

The resin of the present invention has excellent liquid-repellency, and can be used as a patterning material in production of an organic transistor element, a color filter, and an organic EL element. The resin of the present invention can be used in an electronic device including the above organic transistor element, the color filter, and the organic EL element.

The following description will discuss details of an electronic device which is an aspect of the present invention.

The resin of the present invention can be used in an electronic device. More specifically, the resin of the present invention can be used in an electronic device including a photocrosslinked product obtained from a composition containing the resin of the present invention and at least one of an organic solvent and a fluorine-based solvent. Examples of the electronic device include an organic transistor.

A general organic transistor is obtained by providing a gate insulating layer on a substrate, further forming an organic semiconductor layer on the gate insulating layer, and providing a source electrode, a drain electrode, and a gate electrode. An example of an element structure of the organic transistor is illustrated in Fig. 1 as a cross-sectional view. The reference numeral 1001 indicates an element structure of a bottom gate-top contact type. The reference numeral 1002 indicates an element structure of a bottom gate-bottom contact type. The reference numeral 1003 indicates an element structure of a top gate-top contact type. The reference numeral 1004 indicates an element structure of a top gate-bottom contact type. The reference numeral 1 indicates an organic semiconductor layer, the reference numeral 2 indicates a substrate, the reference numeral 3 indicates a gate electrode, the reference numeral 4 indicates a gate insulating layer, the reference numeral 5 indicates a source electrode, and the reference numeral 6 indicates a drain electrode.

An aspect of the organic transistor of the present invention is illustrated in Fig. 2. An organic transistor 1005 illustrated in Fig. 2 corresponds to the bottom gate-bottom contact type 1001 in Fig. 1. The reference numeral 7 indicates a pattern, and the reference numeral 8 indicates a protective film layer.

In the organic transistor, the substrate that can be used is not particularly limited, provided that the substrate can ensure sufficient flatness to produce an element. Examples of the substrate include: inorganic material substrates such as glass, quartz, aluminum oxide, highly doped silicon, silicon oxide, tantalum dioxide, tantalum pentaoxide, and indium tin oxide; plastics; metals such as gold, copper, chromium, titanium, and aluminum; ceramics; coated paper; surface-coated nonwoven fabric; and the like. The substrate may be made of a composite material constituted by these materials or a multilayered material of these materials. It is also possible to coat surfaces of these materials to adjust the surface tension.

Examples of plastic used as the substrate include polyethylene terephthalate, polyethylene naphthalate, triacetyl cellulose, polycarbonate, polymethyl acrylate, polymethyl methacrylate, polyvinyl chloride, polyethylene, an ethylene-vinyl acetate copolymer, polymethylpentene-1, polypropylene, cyclic polyolefin, fluorinated cyclic polyolefin, polystyrene, polyimide, polyvinyl phenol, polyvinyl alcohol, poly(diisopropylfumarate), poly(diethylfumarate), poly(diisopropylmaleate), polyether sulfone, polyphenylene sulfide, polyphenylene ether, a polyester elastomer, a polyurethane elastomer, a polyolefin elastomer, a polyamide elastomer, and a styrene block copolymer. It is possible to stack two or more kinds of the above plastics to be used as a substrate.

An organic semiconductor that can be used in the organic semiconductor layer is not particularly limited. Either an N-type organic semiconductor or a P-type organic semiconductor can be used. Alternatively, it is possible to use a bipolar transistor combining the N-type and the P-type. It is possible to use any of a low-molecular-weight organic semiconductor and a high-molecular-weight organic semiconductor, and it is possible to mix and use those organic semiconductors. Examples of specific compounds of the organic semiconductor include compounds represented by Formulae (E-1) through (E-11) below.

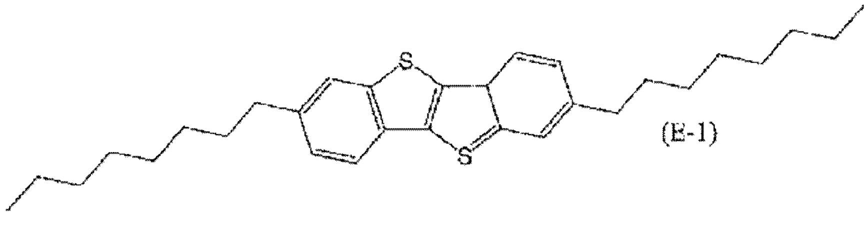

(E-1)

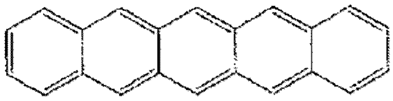
(E-2)

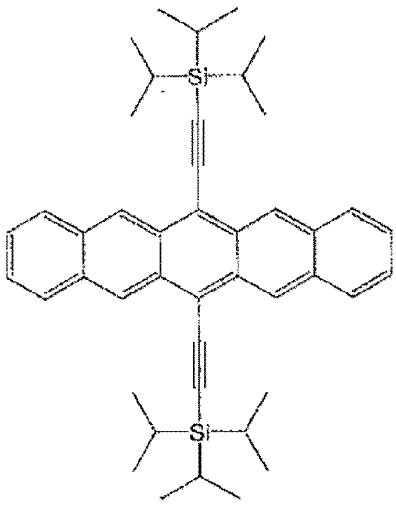
(E-3)

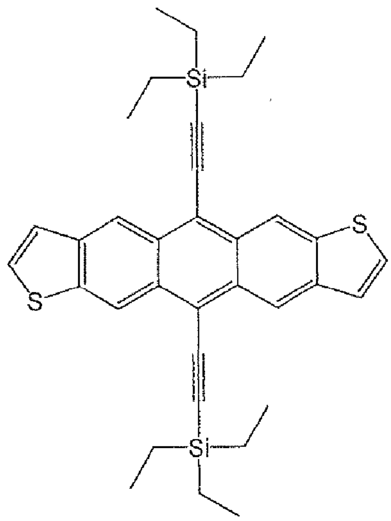
(E-4)

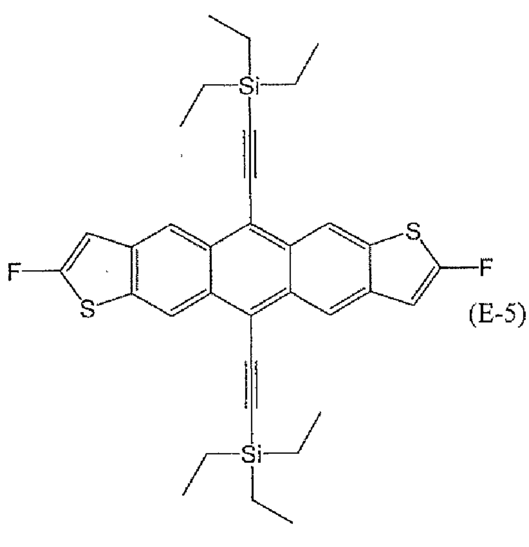
(E-5)

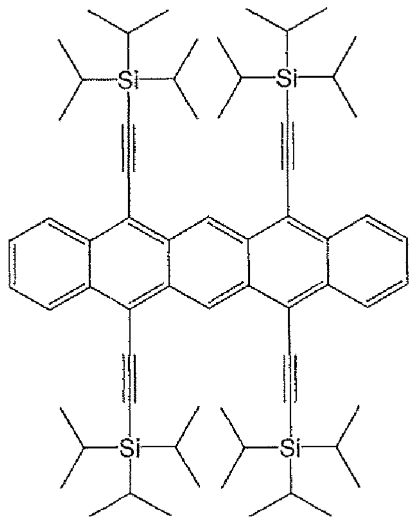

(E-6)

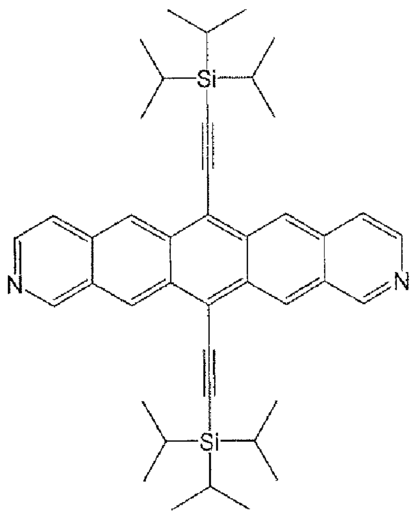

(E-7)

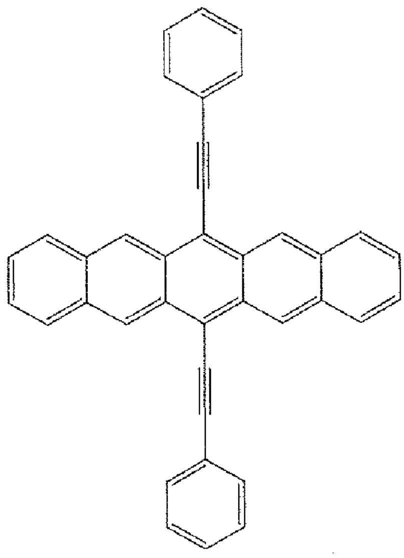

(E-8)

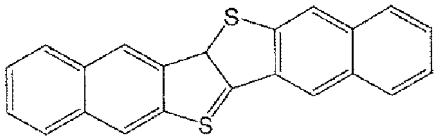
(E-9)

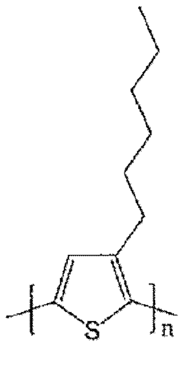
(E-10)

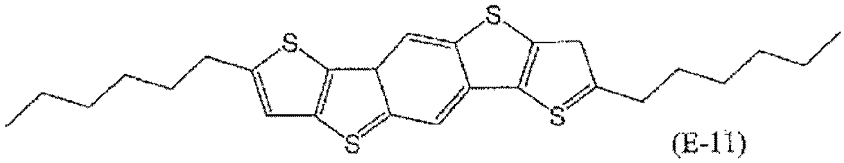
(E-11)

In the present invention, examples of a method for forming an organic semiconductor layer include: a method in which an organic semiconductor is deposited in vacuum; and a method in which an organic semiconductor is dissolved in an organic solvent, and is then applied or printed. The method is not particularly limited, provided that a thin film of an organic semiconductor layer can be formed. A solution concentration in a case where a solution in which the organic semiconductor layer has been dissolved in an organic solvent is applied or printed differs depending on a structure of the organic semiconductor and a solvent used. From the viewpoint of forming a more uniform semiconductor layer and reducing a thickness of the layer, the solution concentration is preferably 0.5 wt% to 5 wt%. The organic solvent used in this case is not particularly limited, provided that the organic semiconductor is dissolved in the organic solvent at a predetermined concentration at which the organic semiconductor can be formed into a film, and examples of the organic solvent include hexane, heptane, octane, decane, dodecane, tetradecane, hexadecane, decalin, indan, 1-methylnaphthalene, 2-ethylnaphthalene, 1,4-dimethylnaphthalene, a dimethylnaphthalene isomer mixture, toluene, xylene, ethylbenzene, 1,2,4-trimethylbenzene, mesitylene, isopropyl benzene, pentylbenzene, hexylbenzene, tetralin, octylbenzene, cyclohexylbenzene, 1,2-dichlorobenzene, 1,3-dichlorobenzene, 1,4-dichlorobenzene, trichlorobenzene, 1,2-dimethoxybenzene, 1,3-dimethoxybenzene, $\gamma$-butyrolactone, 1,3-butylene glycol, ethylene glycol, benzyl alcohol, glycerin, cyclohexanol acetate, 3-methoxy butyl acetate, ethylene glycol monomethyl ether acetate, ethylene glycol monobutyl ether acetate, propylene glycol monomethyl ether acetate, anisole, cyclohexanone, mesitylene, 3-methoxy butyl acetate, cyclohexanol acetate, dipropylene glycol diacetate, dipropylene glycol methyl ether acetate, diethylene glycol monobutyl ether acetate, diethylene glycol monoethyl ether acetate, 1,6-hexanediol diacetate, 1,3-butylene glycol diacetate, 1,4-butanediol diacetate, ethyl acetate, phenyl acetate, dipropylene glycol dimethyl ether, dipropylene glycol methyl-N-propyl ether, tetradecahydrophenanthrene, 1,2,3,4,5,6,7,8-octahydrophenanthrene, decahydro-2-naphthol, 1,2,3,4-tetrahydro-1-naphthol, $\alpha$-terpineol, isophoronetriacetindecahydro-2-naphthol, dipropylene glycol dimethyl ether, 2,6-dimethylanisole, 1,2-dimethylanisole, 2,3-dimethylanisole, 3,4-dimethylanisole, 1-benzothiophene, 3-methylbenzothiophene, 1,2-dichloroethane, 1,1,2,2-tetrachloroethane, chloroform, dichloromethane, tetrahydrofuran, 1,2-dimethoxyethane, dioxane, cyclohexanone, acetone, methyl ethyl ketone, diethyl ketone, diisopropyl ketone, acetophenone, N,N-dimethylformamide, N-methyl-2-pyrolidone, limonene, and the like. In order to obtain a crystalline film having a preferable property, a solvent having high solvency to dissolve an organic semiconductor and a boiling point of 100°C or more is suitable. Such a solvent is preferably xylene, isopropyl benzene, anisole, cyclohexanone, mesitylene, 1,2-dichlorobenzene, 3,4-dimethylanisole, pentylbenzene, tetralin, cyclohexylbenzene, or decahydro-2-naphthol. It is possible to use a mixed solvent in which two or more of the above solvents are mixed at an appropriate ratio.

To the organic semiconductor layer, various organic and inorganic polymers or oligomers, organic and inorganic nanoparticles as a solid, or a dispersion solution in which the nanoparticles are dispersed in water or an organic solvent can be added according to need. A polymer solution can be applied onto the above insulating layer to form a protective film. Moreover, it is possible to provide various kinds of moistureproof coating, lightfast coating, and the like on the protective

film according to need.

Examples of the gate electrode, the source electrode, or the drain electrode that can be used in the present invention include conductive materials such as: inorganic electrodes such as aluminum, gold, silver, copper, highly doped silicon, polysilicon, silicide, tin oxide, indium oxide, indium tin oxide, chromium, platinum, titanium, tantalum, graphene, carbon nanotubes: and organic electrodes such as a doped conductive polymer (e.g., PEDOT-PSS) or the like. A plurality of these conductive materials can be laminated and used. It is possible to carry out surface treatment using a surface treatment agent on these electrodes in order to increase carrier injection efficiency. Examples of such a surface treatment agent include benzenethiol, pentafluorobenzenethiol, and the like.

There is no particular limitation to a method of forming an electrode on the above substrate, insulating layer, or organic semiconductor layer. Examples of the method include deposition, high-frequency sputtering, electron beam sputtering, and the like. It is possible to employ a method in which solution spin coating, drop casting, dip coating, doctor blade, die coating, pad printing, roller coating, gravure printing, flexo printing, super flexo printing, screen printing, inkjet printing, letterpress reverse printing, or the like is carried out with use of ink in which nanoparticles of the above conductive material are dissolved in water or an organic solvent.

The resin of the present invention can be suitably used for a pattern and a protective film layer in an organic transistor.

From the viewpoint of practicality of an organic transistor element, the organic transistor in accordance with an aspect of the present invention has mobility of preferably 0.20 $cm^2/Vs$ or more.

From the viewpoint of practicality of an organic transistor element, the organic transistor in accordance with an aspect of the present invention has an on current-to-off current ratio of preferably $10^5$ or more.

From the viewpoint of practicality of an organic transistor element, the organic transistor in accordance with an aspect of the present invention preferably does not involve hysteresis of electric current between the source and the drain.

<Summary>

As understood from the above descriptions, the present invention includes the following features.

<1> A resin including: a repeating unit that is represented by Formula (1) below including a photocrosslinkable group; and one or more units selected from the group consisting of a repeating unit that includes a fluorine atom, a repeating unit that includes an acidic functional group and a repeating unit that includes a hydrophilic functional group,

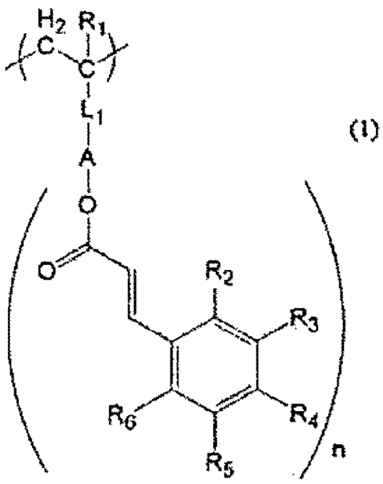

(1)

where $R_1$ represents a hydrogen atom or a methyl group, $L_1$ represents a single bond or a bivalent linking group, A represents a linking group having a valence of m, $R_2$, $R_3$, $R_4$, $R_5$, and $R_6$, which are identical to each other or different from each other, each represent one selected from the group consisting of a hydrogen atom, a halogen atom, linear alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group, m represents an integer of 3 or more, and n represents an integer of m-1.

<2> The resin described in <1>, in which: as at least one of the repeating unit that includes an acidic functional group and the repeating unit that includes a hydrophilic functional group, the resin includes a repeating unit that includes a functional group selected from a carboxyl group, a sulfo group, a phenolic hydroxyl group, an alcoholic hydroxyl group, an amide group, an amino group, and a cyano group.

<3> The resin described in <1> or <2>, in which: as at least one of the repeating unit that includes an acidic functional group and the repeating unit that includes a hydrophilic functional group, the resin includes a repeating unit represented by Formula (a) below,

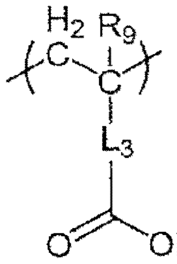
(a)

where $R_9$ represents a hydrogen atom or a methyl group, and $L_3$ represents a single bond or a bivalent linking group.
<4> The resin described in any one of <1> through <3>, in which: as the repeating unit that includes a fluorine atom, the resin includes a repeating unit represented by Formula (2) below,

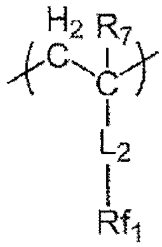
(2)

where $R_7$ represents a hydrogen atom or a methyl group, $L_2$ represents a single bond or a bivalent linking group, and $Rf_1$ represents one selected from the group consisting of linear fluoroalkyl groups having 1 to 15 carbon atoms, branched fluoroalkyl groups having 3 to 15 carbon atoms, and cyclic fluoroalkyl groups having 3 to 15 carbon atoms.
<5> The resin described in any one of <1> through <4>, in which: in the above Formula (1), A is one linking group selected from the group consisting of Formulae (a-1) through (a-4) below,

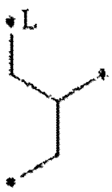
(a-1)

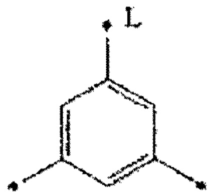
(a-2)

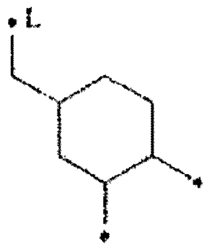
(a-3)

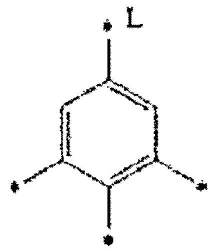
(a-4)

where *L represents a linkage position with $L_1$ in the above Formula (1), and * at an end of a carbon atom represents a linkage position with an oxygen atom constituting an ester group in the above Formula (1).
<6> The resin described in <5>, in which: in the above Formula (1), A is a linking group represented by the above Formula (a-1).
<7> The resin described in any one of <1> through <6>, which is soluble in an alkaline solution.
<8> A composition, including: a resin described in any one of <1> through <7>; and at least one of an organic solvent and a fluorine-based solvent.
<9> A photocrosslinked product, which is obtained from a resin described in any one of <1> through <7> or from a composition described in <8>.
<10> A pattern, which is constituted by a photocrosslinked product described in <9>.
<11> An electronic device, including a photocrosslinked product described in <9>.

Examples

The following description will discuss the present invention in greater detail with reference to Examples. However, the present invention is not limited to the following Examples.

Examples employed the following conditions and devices.

<Monomer purity>

Gas chromatography device; manufactured by Shimadzu Corporation, (product name) GC2014
Column; manufactured by RESTEK, (product name) Rxi-1HT, 30 m
The above gas chromatography device (GC) was used to analyze purity of a monomer.

<Composition of resin>

With use of a nuclear magnetic resonance measurement device (manufactured by JEOL Ltd., product name: JNM-ECZ400S), a composition of a resin was obtained by proton nuclear magnetic resonance ($^1$H-NMR) spectroscopic analysis.

<Spin coating>

MS-A100 manufactured by MIKASA CO., LTD. was used.

<Measurement of film thickness>

Measurement was carried out using a DektakXT stylus profiler manufactured by Bruker.

<UV irradiation>

Using a UV mask aligner, UPE-1605MA manufactured by USHIO LIGHTING, INC., a UV irradiation time was adjusted by changing a transferring speed under a condition of UV intensity of 14.2 mW/cm$^2$.

<Laser microscope>

A laser microscope, OPTELICS HYBRID manufactured by Lasertec Corporation, was used to check an organic semiconductor layer or a pattern which has been inkjet-printed.

In Examples, the following results were obtained.

Synthesis Example 1 (synthesis of photocrosslinkable monomer 1)

Under a nitrogen atmosphere, 24 g of glycerin monomethacrylate (BLEMMER GLM, NOF CORPORATION), 32 g of triethylamine, and 31 g of toluene were introduced into a 500 mL flask, and the resultant mixture was sufficiently mixed together. Moreover, under a nitrogen atmosphere, 72 g of cinnamic acid chloride and 172 g of toluene were introduced into a glass vial and the resultant mixture was dissolved. Then, nitrogen was introduced into the flask containing the glycerin monomethacrylate, the triethylamine, and the tetrahydrofuran, and the solution in which the cinnamic acid chloride had been dissolved was dripped with used of a dripping funnel, and a resultant mixture was stirred for 4 hours. After that, the resultant mixture was filtered to remove a salt which is a by-product, and toluene was removed with an aspirator and vacuum drying. After that, the product was dissolved in 70 g of ethanol for recrystallization, and then deposited powder was vacuum-dried. As a result, it was found that the deposited powder was a substance (photocrosslinkable monomer 1) represented by Formula (5) below. (GC purity: 96%)

(Photocrosslinkable monomer 1)

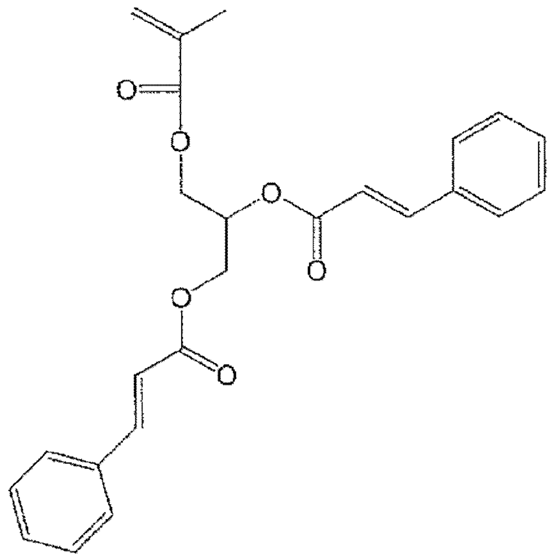

(5)

Example 1 (polymerization of resin 1)

Into a glass ampule having a capacity of 75 mL, 1.44 g of the photocrosslinkable monomer 1 obtained in Synthesis Example 1, 1.4 g of 1H,1H,2H,2H-tridecafluoro-n-octyl methacrylate, 2.23 g of methacrylic acid, 0.25 g of PERHEXYL ND (manufactured by NOF CORPORATION) as a polymerization initiator, 0.15 g of 2,4-diphenyl-4-methyl-1-pentene as a chain transfer agent, and 11.8 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.5 g of a resin 1 was obtained (yield: approximately 91%). From $^1$H-NMR measurement of the resin 1, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit 1) [C-16]/methacrylic acid (acidic functional group unit 1) [D-1] = 11/8/81 (mol%), and the resin 1 was a copolymer represented by Formula (6).

(Resin 1)

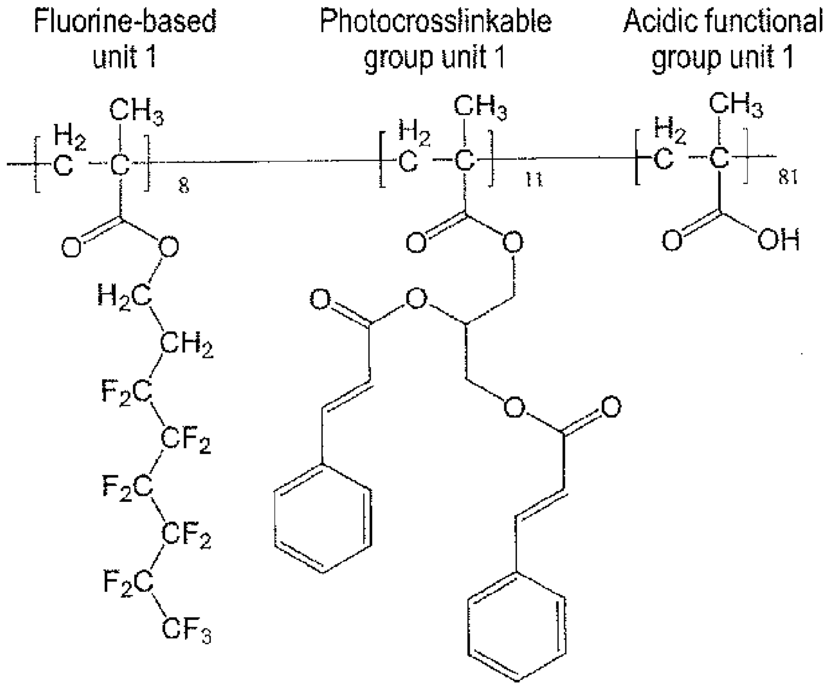


(6)

Example 2 (polymerization of resin 2)

Into a glass ampule having a capacity of 75 mL, 1.17 g of the photocrosslinkable monomer 1 obtained in Synthesis Example 1, 2.29 g of 1H,1H,2H,2H-tridecafluoro-n-octyl methacrylate, 1.60 g of methacrylic acid, 0.21 g of PERHEXYL ND (manufactured by NOF CORPORATION) as a polymerization initiator, 0.16 g of 2,4-diphenyl-4-methyl-1-pentene as a chain transfer agent, and 11.8 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.6 g of a resin 2 was obtained (yield: approximately 91%). From $^1$H-NMR measurement of the resin 2, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit 1) [C-16]/methacrylic acid (acidic functional group unit 1) [D-1] = 11/18/71 (mol%), and the resin 2 was a copolymer represented by Formula (7).

(Resin 2)

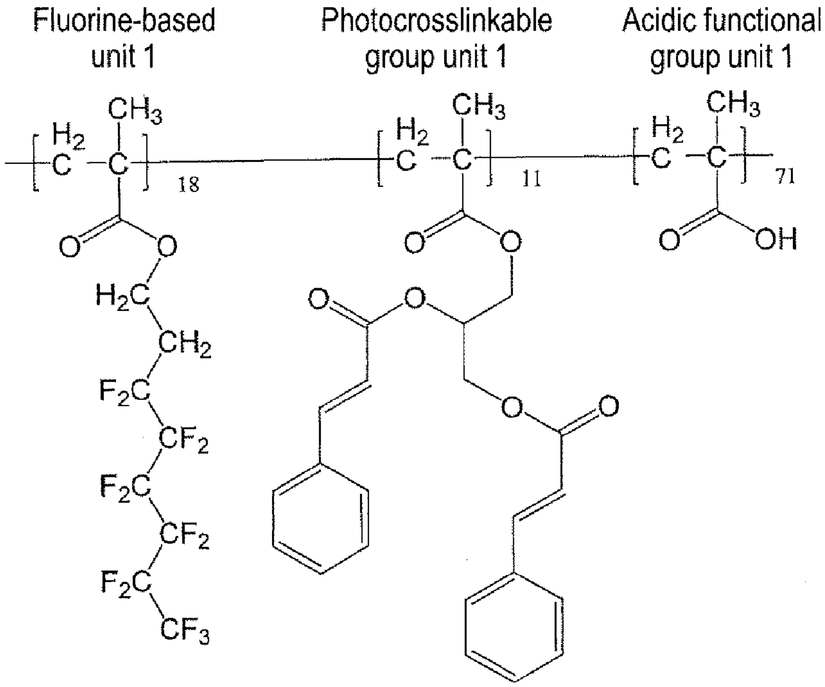


(7)

Example 3 (polymerization of resin 3)

Into a glass ampule having a capacity of 75 mL, 1.61 g of the photocrosslinkable monomer 1 obtained in Synthesis Example 1, 2.1 g of 1H,1H,2H,2H-tridecafluoro-n-octyl methacrylate, 1.62 g of methacrylic acid, 0.19 g of PERHEXYL ND (manufactured by NOF CORPORATION) as a polymerization initiator, 0.12 g of 2,4-diphenyl-4-methyl-1-pentene as a chain transfer agent, and 11.9 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.26 g of a resin 3 was obtained (yield: approximately 85%). From $^{1}$H-NMR measurement of the resin 3, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit 1) [C-16]/methacrylic acid (acidic functional group unit 1) [D-1] = 15/20/65 (mol%), and the resin 3 was a copolymer represented by Formula (8).

(Resin 3)

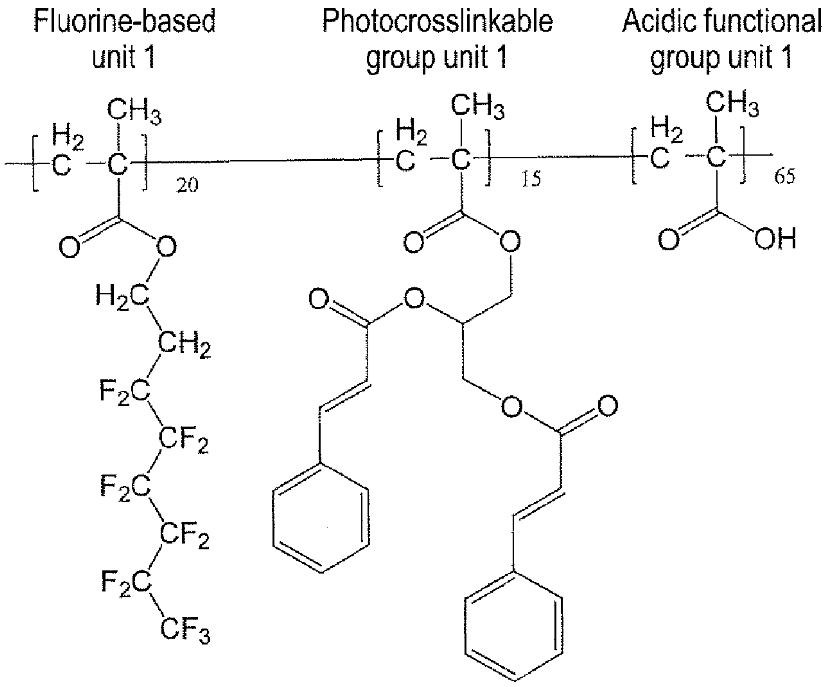


(8)

Example 4 (polymerization of resin 4)

Into a glass ampule having a capacity of 75 mL, 1.99 g of the photocrosslinkable monomer 1 obtained in Synthesis Example 1, 1.95 g of 1H,1H,2H,2H-tridecafluoro-n-octyl methacrylate, 1.16 g of methacrylic acid, 0.18 g of PERHEXYL ND (manufactured by NOF CORPORATION) as a polymerization initiator, 0.11 g of 2,4-diphenyl-4-methyl-1-pentene as a chain transfer agent, and 11.9 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.57 g of a resin 4 was obtained (yield: approximately 91%). From $^1$H-NMR measurement of the resin 4, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit 1) [C-16]/methacrylic acid (acidic functional group unit 1) [D-1] = 21/18/61 (mol%), and the resin 4 was a copolymer represented by Formula (9).

(Resin 4)

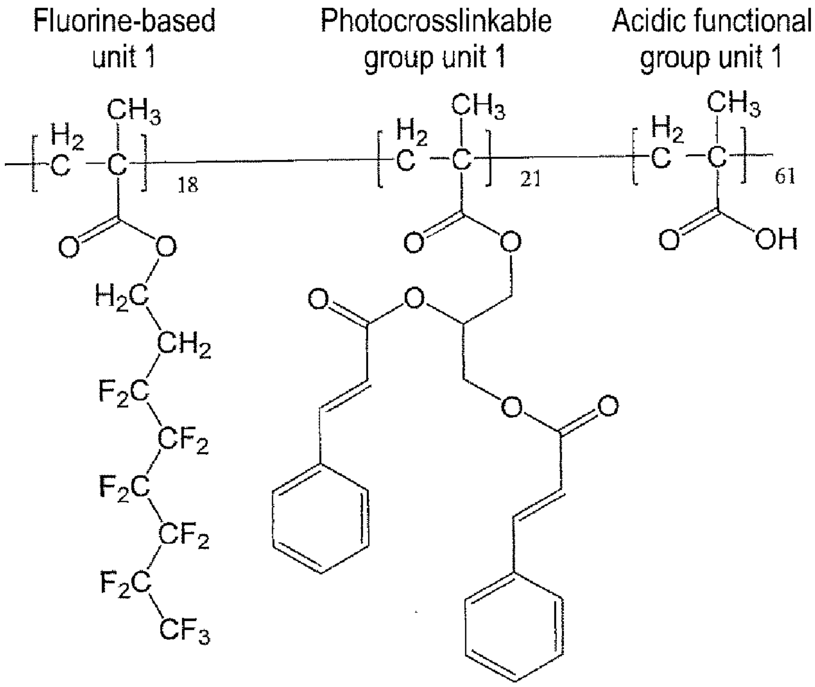

(9)

Example 5 (polymerization of resin 5)

Into a glass ampule having a capacity of 75 mL, 2.19 g of the photocrosslinkable monomer 1 obtained in Synthesis Example 1, 1.64 g of 1H,1H,2H,2H-nonafluorohexyl methacrylate, 1.28 g of methacrylic acid, 0.19 g of PERHEXYL ND (manufactured by NOF CORPORATION) as a polymerization initiator, 0.12 g of 2,4-diphenyl-4-methyl-1-pentene as a chain transfer agent, and 11.9 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.6 g of a resin 5 was obtained (yield: approximately 91%). From $^1$H-NMR measurement of the resin 5, it was found that the composition thereof was as follows: photocrosslinkable monomer 1 (photocrosslinkable group unit 1) [B-1]/1H,1H,2H,2H-nonafluorohexyl methacrylate (fluorine-based unit 2) [C-14]/methacrylic acid (acidic functional group unit 1) [D-1] = 22/17/61 (mol%), and the resin 5 was a copolymer represented by Formula (10).

(Resin 5)

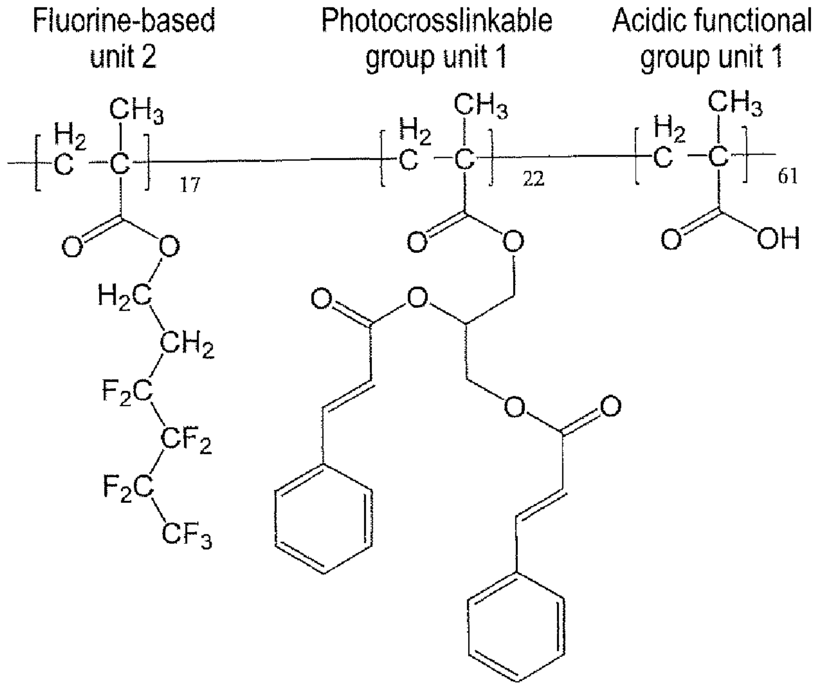


(10)

Example 6 (polymerization of resin 6)

Into a glass ampule having a capacity of 75 mL, 2.12 g of the photocrosslinkable monomer 1 obtained in Synthesis Example 1, 1.66 g of 1H,1H,2H,2H-nonafluorohexyl methacrylate, 1.28 g of methacrylic acid, 0.19 g of PERHEXYL ND (manufactured by NOF CORPORATION) as a polymerization initiator, 0.06 g of 2,4-diphenyl-4-methyl-1-pentene as a chain transfer agent, and 11.8 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.2 g of a resin 6 was obtained (yield: approximately 84%). From $^1$H-NMR measurement of the resin 6, it was found that the composition thereof was as follows: photocrosslinkable monomer 1 (photocrosslinkable group unit 1) [B-1]/1H,1H,2H,2H-nonafluorohexyl methacrylate (fluorine-based unit 2) [C-14]/methacrylic acid (acidic functional group unit 1) [D-1] = 28/21/51 (mol%), and the resin 6 was a copolymer represented by Formula (11).

(Resin 6)

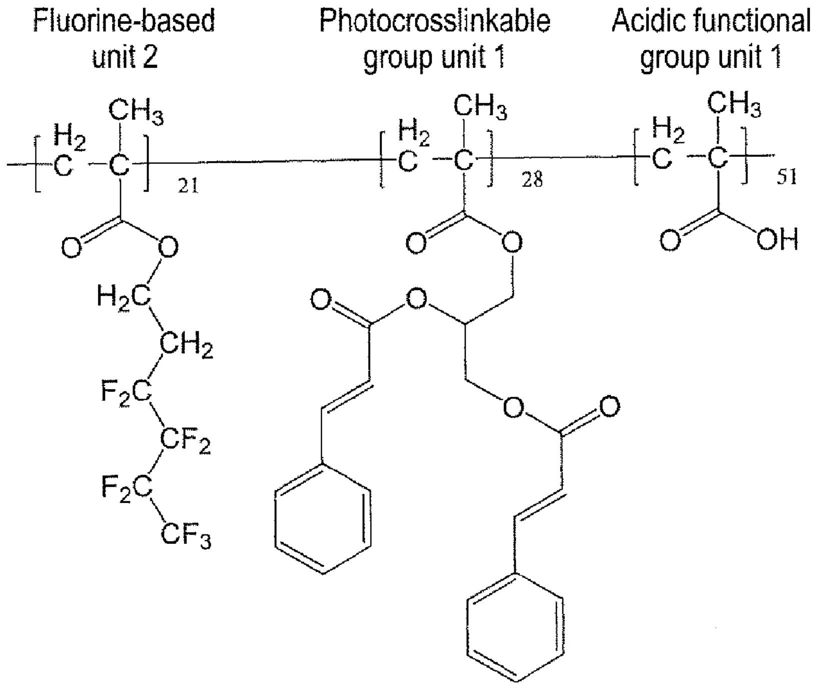


(11)

Example 7 (polymerization of resin 7)

Into a glass ampule having a capacity of 75 mL, 2.56 g of the photocrosslinkable monomer 1 obtained in Synthesis Example 1, 2.62 g of mono-2-(methacryloyloxy)ethyl phthalate, 0.29 g of PERHEXYL ND (manufactured by NOF CORPORATION) as a polymerization initiator, 0.35 g of 2,4-diphenyl-4-methyl-1-pentene as a chain transfer agent, and 12.1 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.8 g of a resin 7 was obtained (yield: approximately 96%). From $^1$H-NMR measurement of the resin 7, it was found that the composition thereof was as follows: photocrosslinkable monomer 1 (photocrosslinkable group unit 1) [B-1]/mono-2-(methacryloyloxy)ethyl phthalate (acidic functional group unit 2) [D-22] = 52/48 (mol%), and the resin 7 was a copolymer represented by Formula (12).

(Resin 7)

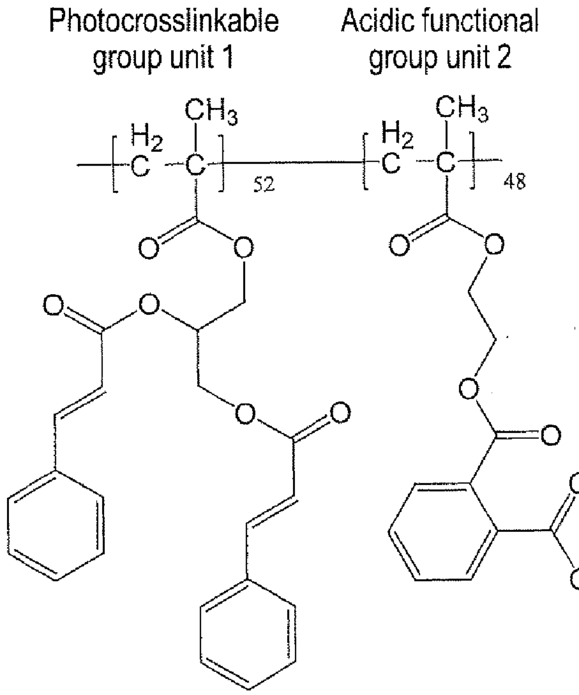


(12)

Example 8 (polymerization of resin 8)

Into a glass ampule having a capacity of 75 mL, 4.12 g of the photocrosslinkable monomer 1 obtained in Synthesis Example 1, 1.00 g of methacrylic acid, 0.41 g of PERHEXYL ND (manufactured by NOF CORPORATION) as a polymerization initiator, 0.62 g of 2,4-diphenyl-4-methyl-1-pentene as a chain transfer agent, and 11.9 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of hexane so as to be deposited, and then cleaned with 150 mL of hexane twice. Further, the cleaned substance was dried in vacuum at 40°C for 8 hours, and thus 4.2 g of a resin 8 was obtained (yield: approximately 84%). From $^1$H-NMR measurement of the resin 8, it was found that the composition thereof was as follows: photocrosslinkable monomer 1 (photocrosslinkable group unit 1) [B-1]/methacrylic acid (acidic functional group unit 1) [D-1] = 40/60 (mol%), and the resin 8 was a copolymer represented by Formula (13).

(Resin 8)

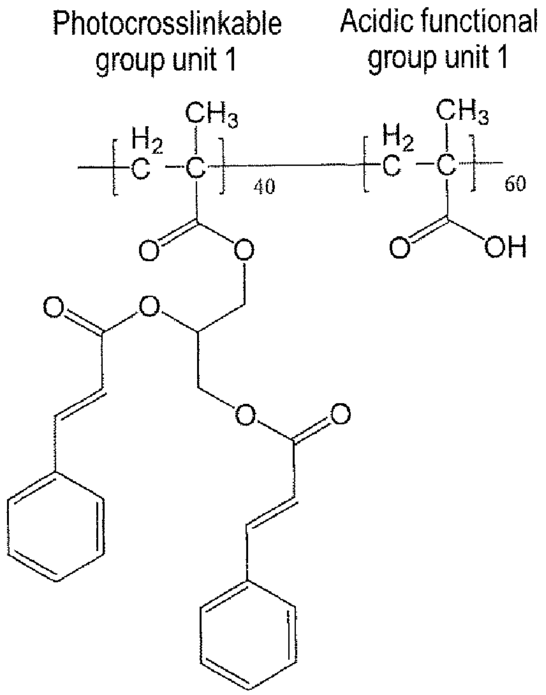


(13)

Example 9 (polymerization of resin 9)

Into a glass ampule having a capacity of 75 mL, 3.07 g of the photocrosslinkable monomer 1 obtained in Synthesis Example 1, 2.29 g of mono(2-acryloyloxyethyl) succinate, 0.33 g of PERHEXYL ND (manufactured by NOF CORPORATION) as a polymerization initiator, 0.40 g of 2,4-diphenyl-4-methyl-1-pentene as a chain transfer agent, and 12.5 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of a 1:1 mixed solvent of toluene and hexane so as to be deposited, and then cleaned with 150 mL of hexane twice. Further, the cleaned substance was dried in vacuum at 40°C for 8 hours, and thus 3 g of a resin 9 was obtained (yield: approximately 60%). From $^1$H-NMR measurement of the resin 9, it was found that the composition thereof was as follows: photocrosslinkable monomer 1 (photocrosslinkable group unit 1) [B-1]/mono(2-acryloyloxyethyl) succinate (acidic functional group unit 3) [D-21] = 54/46 (mol%), and the resin 9 was a copolymer represented by Formula (14).

(Resin 9)

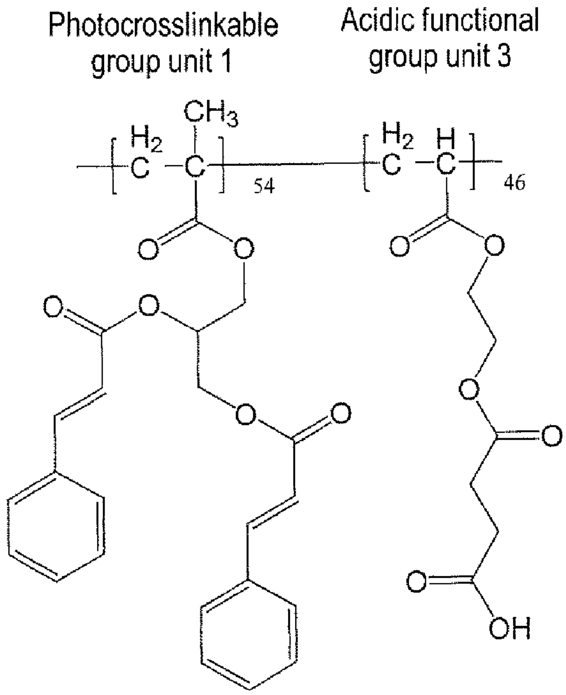


(14)

Example 10 (mixture of resin 6 and resin 7)

The resin 6 and the resin 7 which had been obtained as described above were mixed at a ratio of 2:20 (wt%) to obtain a resin mixture.

Example 11 (mixture of resin 6 and resin 9)

The resin 6 and the resin 9 which had been obtained as described above were mixed at a ratio of 2:20 (wt%) to obtain a resin mixture.

Comparative Example 1 (polymerization of resin A)

Into a glass ampule having a capacity of 75 mL, 3.82 g of the photocrosslinkable monomer 1 obtained in Synthesis Example 1, 1.32 g of methyl methacrylate, 0.17 g of PERHEXYL ND (manufactured by NOF CORPORATION) as a polymerization initiator, 0.05 g of 2,4-diphenyl-4-methyl-1-pentene as a chain transfer agent, and 12 g of 2-butanone were introduced. Replacement of inside gas with nitrogen and depressurization were repeated, and then the glass ampule was sealed by welding in a reduced-pressure state. This ampule was placed in a constant temperature bath at 45°C, and maintained for 24 hours to carry out radical polymerization. After the completion of the polymerization reaction, a polymer solution was taken out from the ampule, and the polymer solution was dripped onto 300 mL of methanol so as to be deposited, and then cleaned with 150 mL of methanol twice. Further, the cleaned substance was dried in vacuum at 30°C for 8 hours, and thus 4 g of a resin A was obtained (yield: approximately 80%). From $^{1}$H-NMR measurement of the resin A, it was found that the composition thereof was as follows: photocrosslinkable monomer 1 (photocrosslinkable group unit 1) [B-1]/methyl methacrylate (another unit) = 40/60 (mol%), and the resin A was a copolymer represented by Formula (15).

(Resin A)

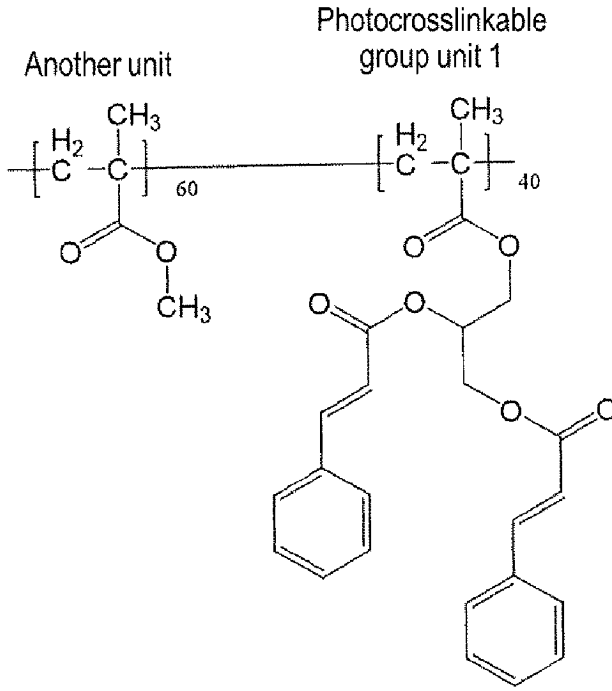


(15)

<Evaluation of solubility in alkaline solution>

Each of the synthesized resins 1 through 9 and resin A was added to the following fluorine-based solvent (solvent 1) so that an amount of the resin in a resultant mixture was 1 wt%, and the mixture was mixed at normal temperature. Then, whether or not the resin was dissolved by 1-hour stirring was visually checked. Results are shown in Table 1. In Table 1, the presence of an insoluble component is indicated as "insoluble", and the absence of such a component is indicated as "dissolved".

Solvent 1: tetramethylammonium hydroxide aqueous solution (2.38%)

It was found that the resins 1 through 9 were dissolved in the alkaline solution.

[Table 1]

| | Resin | Solvent 1 |
|---|---|---|
| Example 1 | Resin 1 | Dissolved |
| Example 2 | Resin 2 | Dissolved |
| Example 3 | Resin 3 | Dissolved |
| Example 4 | Resin 4 | Dissolved |
| Example 5 | Resin 5 | Dissolved |
| Example 6 | Resin 6 | Dissolved |
| Example 7 | Resin 7 | Dissolved |
| Example 8 | Resin 8 | Dissolved |
| Example 9 | Resin 9 | Dissolved |
| Comparative Example 1 | Resin A | Insoluble |

<Evaluation of liquid-repellency (water-repellency, oil-repellency) >

A solution of the resin 1 or 2 (3 wt%, solvent: N,N-dimethylformamide), a solution of any of the resins 3 through 6 or the resin A (3 wt%, solvent: propylene glycol monomethyl ether acetate), a mixture solution of the resin 6 and resin 7 or a

mixture solution of the resin 6 and resin 9 (resin 6: 2 wt%, resin 7 or 9: 20 wt%, solvent: propylene glycol monomethyl ether acetate: 78 wt%) was spin-coated onto a cleaned and dried glass having a size of 30 × 30 $mm^2$ (EagleXG manufactured by Corning) under conditions of 500 rpm × 5 seconds and 1500 rpm × 20 seconds. UV irradiation was carried out by irradiation with ultraviolet rays of 2000 $mJ/cm^2$. Using a contact angle meter (manufactured by Kyowa Interface Science Co., Ltd., product name: DM-300), contact angles were measured with respect to water, diiodomethane, m-xylene, and tetralin by the θ/2 method. Results are shown in Table 2.

It was found that the resins 1 through 6, the mixture of the resins 6 and 7, and the mixture of the resins 6 and 9 had excellent liquid-repellency. In contrast, the resin A did not exhibit excellent liquid-repellency.

[Table 2]

| Type | Resin | Contact angle (°) | | | |
|---|---|---|---|---|---|
| | | Water | Diiodomethane | Tetralin | Xylene |
| Example 1 | Resin 1 | 100 | 82 | 64 | 54 |
| Example 2 | Resin 2 | 104 | 86 | 69 | 60 |
| Example 3 | Resin 3 | 104 | 84 | 67 | 56 |
| Example 4 | Resin 4 | 106 | 85 | 68 | 46 |
| Example 5 | Resin 5 | 97 | 77 | 60 | 46 |
| Example 6 | Resin 6 | 101 | 81 | 63 | 51 |
| Example 10 | Mixture of resins 6 and 7 | 100 | 81 | 62 | 50 |
| Example 11 | Mixture of resins 6 and 9 | 100 | 80 | 61 | 50 |
| Comparative Example 1 | Resin A | 77 | 35 | <5 | <5 |

<Evaluation of curability (crosslinkability) and pattern formation>

In order to evaluate curability, each of the resins 1 through 9, the mixture of the resins 6 and 7, the mixture of the resins 6 and 9, and the resin A was dissolved in a solvent under a sensitizer addition condition indicated in Table 3, and thus a solution was prepared. After that, the solution was formed into a film with a spin coater on a cleaned and dried glass substrate having a size of 30 × 30 $mm^2$ (EagleXG manufactured by Corning) under conditions of 500 rpm × 5 seconds and 1500 rpm × 20 seconds, and a resultant film was sufficiently dried. Then, the film was irradiated with UV of 100 $mJ/cm^2$ to 1000 $mJ/cm^2$ so that the resin film was photocrosslinked. The thickness of this film was measured with the DektakXT stylus profiler manufactured by Bruker, and the thickness was indicated as $T_0$. Next, the glass plate coated with the photocrosslinked resin film was immersed in a tetramethylammonium hydroxide aqueous solution (2.38%), which is a good solvent for the resin, for 1 minute, and then taken out. The film thickness was measured after drying at 150°C for 10 minutes using a hot plate, and the thickness was indicated as $T_1$. Using these measured film thicknesses, a residual film ratio (R) was calculated based on the following equation.

$$R = T_1/T_0 \times 100\ (\%)$$

Photocrosslinking (curing) property was evaluated using a residual film ratio (R) of 95% or more as a determination criterion for crosslinking. Note that, as a UV radiation quantity for reaching a residual film ratio of 95% or more decreases, photocrosslinkability is higher (faster). Resins which achieved R of 95% or more with the UV radiation quantity of 1000 $mJ/cm^2$ or less were determined to be "crosslinked".

For pattern formation evaluation, as a mask for pattern formation, a mask patterned with chromium was used. The patterns each had a shape constituted by a square which had sides of 50 μm, and the patterns were arranged in a matrix of 10 × 10. On a glass substrate having a size of 100 × 100 $mm^2$, the above solution was spin-coated to obtain a film, and the mask was provided on the obtained film, and the film was irradiated with UV in a radiation quantity which derived a residual film ratio of 95% or more in the curability evaluation. After the irradiation, uncrosslinked portions were cleaned and removed with a tetramethylammonium hydroxide aqueous solution (2.38%) for 1 minute, and whether or not a pattern having the shape with 100 holes each having a size of 10 × 10 $\mu m^2$ or 50 × 50 $\mu m^2$ was formed on the film was checked using a laser microscope.

Solvent 2: N,N-dimethylformamide

Solvent 3: Propylene glycol monomethyl ether acetate

Sensitizer 1: 4,4'-bis(diethylamino)benzophenone (manufactured by Tokyo Chemical Industry Co., Ltd.)

The resins 1 through 9, the mixture of the resins 6 and 7, and the mixture of the resins 6 and 9 had a residual film ratio of 95% or more at 1000 mJ/cm$^2$ or less, and thus exhibited excellent photocurability. In contrast, the resin A was insoluble in the tetramethylammonium hydroxide aqueous solution (2.38%), and therefore could not be evaluated.
The resins 1 through 9, the mixture of the resins 6 and 7, and the mixture of the resins 6 and 9 each formed a pattern, and thus exhibited excellent patterning property. In contrast, the resin A was insoluble in the tetramethylammonium hydroxide aqueous solution (2.38%), and therefore could not form a pattern.
[Table 3]

| | Solution | | | Solution concentration [%] | | | Curability evaluation | | Pattern formation |
|---|---|---|---|---|---|---|---|---|---|
| | Resin | Solvent | Sensitizer | Resin (1 to 6) | Resin (7 to 9) | Sensitizer | Light exposure intensity [mJ/cm$^2$] | Crosslink determination | |
| Example 1 | Resin 1 | 2 | - | 3 | - | - | 1000 | Crosslinked | Formed |
| Example 2 | Resin 2 | 2 | 1 | 3 | - | 0.1 | 500 | Crosslinked | Formed |
| Example 3 | Resin 3 | 3 | 1 | 10 | - | 0.3 | 500 | Crosslinked | Formed |
| Example 4 | Resin 4 | 3 | 1 | 10 | - | 0.3 | 250 | Crosslinked | Formed |
| Example 5 | Resin 5 | 3 | 1 | 10 | - | 0.3 | 250 | Crosslinked | Formed |
| Example 6 | Resin 6 | 3 | 1 | 10 | - | 0.3 | 250 | Crosslinked | Formed |
| Example 7 | Resin 7 | 3 | 1 | - | 20 | 0.4 | 500 | Crosslinked | Formed |
| Example 8 | Resin 8 | 3 | 1 | - | 20 | 0.4 | 500 | Crosslinked | Formed |
| Example 9 | Resin 9 | 3 | 1 | - | 20 | 0.4 | 500 | Crosslinked | Formed |
| Example 10 | Mixture of resins 6 and 7 | 3 | 1 | 2 | 20 | 0.4 | 500 | Crosslinked | Formed |
| Example 11 | Mixture of resins 6 and 9 | 3 | 1 | 2 | 20 | 0.4 | 500 | Crosslinked | Formed |
| Comparative Example 1 | Resin A | 3 | 1 | 10 | | 0.3 | - | - | Not formed |

Reference Signs List

1: Organic semiconductor layer
2: Substrate
3: Gate electrode
4: Gate insulating layer
5: Source electrode
6: Drain electrode
7: Pattern
8: Protective film layer

## Claims

1. A resin comprising:

a repeating unit that is represented by Formula (1) below including a photocrosslinkable group; and
one or more units selected from the group consisting of a repeating unit that includes a fluorine atom, a repeating unit that includes an acidic functional group and a repeating unit that includes a hydrophilic functional group,

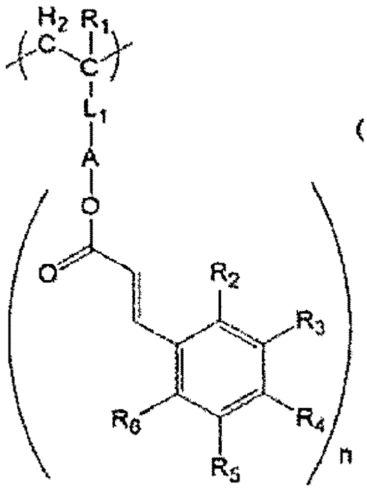

(1)

where $R_1$ represents a hydrogen atom or a methyl group, $L_1$ represents a single bond or a bivalent linking group, A represents a linking group having a valence of m, $R_2$, $R_3$, $R_4$, $R_5$, and $R_6$, which are identical to each other or different from each other, each represent one selected from the group consisting of a hydrogen atom, a halogen atom, linear alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group, m represents an integer of 3 or more, and n represents an integer of m-1.

2. The resin as set forth in claim 1, wherein:
as at least one of the repeating unit that includes an acidic functional group and the repeating unit that includes a hydrophilic functional group, said resin comprises a repeating unit that includes a functional group selected from a carboxyl group, a sulfo group, a phenolic hydroxyl group, an alcoholic hydroxyl group, an amide group, an amino group, and a cyano group.

3. The resin as set forth in claim 1 or 2, wherein:

as at least one of the repeating unit that includes an acidic functional group and the repeating unit that includes a hydrophilic functional group, said resin comprises a repeating unit represented by Formula (a) below,

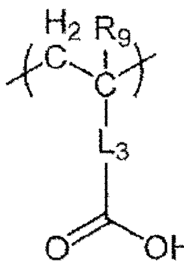

(a)

where $R_9$ represents a hydrogen atom or a methyl group, and $L_3$ represents a single bond or a bivalent linking group.

4. The resin as set forth in claim 1 or 2, wherein:

as the repeating unit that includes a fluorine atom, said resin comprises a repeating unit represented by Formula (2) below,

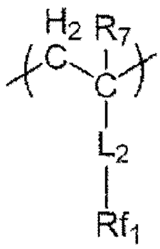

(2)

where $R_7$ represents a hydrogen atom or a methyl group, $L_2$ represents a single bond or a bivalent linking group, and $Rf_1$ represents one selected from the group consisting of linear fluoroalkyl groups having 1 to 15 carbon atoms, branched fluoroalkyl groups having 3 to 15 carbon atoms, and cyclic fluoroalkyl groups having 3 to 15 carbon atoms.

**5.** The resin as set forth in claim 1 or 2, wherein:

in the above Formula (1), A is one linking group selected from the group consisting of Formulae (a-1) through (a-4) below,

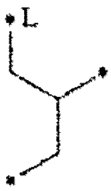

(a-1)

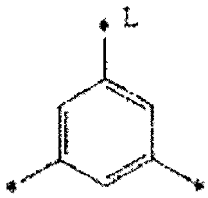

(a-2)

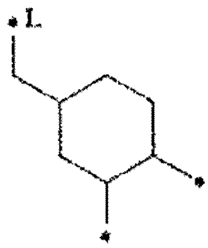

(a-3)

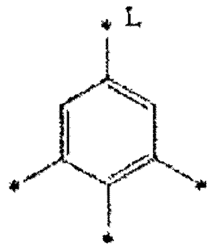

(a-4)

where *L represents a linkage position with $L_1$ in the above Formula (1), and * at an end of a carbon atom represents a linkage position with an oxygen atom constituting an ester group in the above Formula (1).

**6.** The resin as set forth in claim 5, wherein:
in the above Formula (1), A is a linking group represented by the above Formula (a-1).

**7.** The resin as set forth in claim 1 or 2, which is soluble in an alkaline solution.

**8.** A composition, comprising:

a resin recited in claim 1; and
at least one of an organic solvent and a fluorine-based solvent.

**9.** A photocrosslinked product, which is obtained from a resin recited in claim 1 or 2 or from a composition recited in claim 8.

**10.** A pattern, which is constituted by a photocrosslinked product recited in claim 9.

**11.** An electronic device, comprising a photocrosslinked product recited in claim 9.

FIG. 1

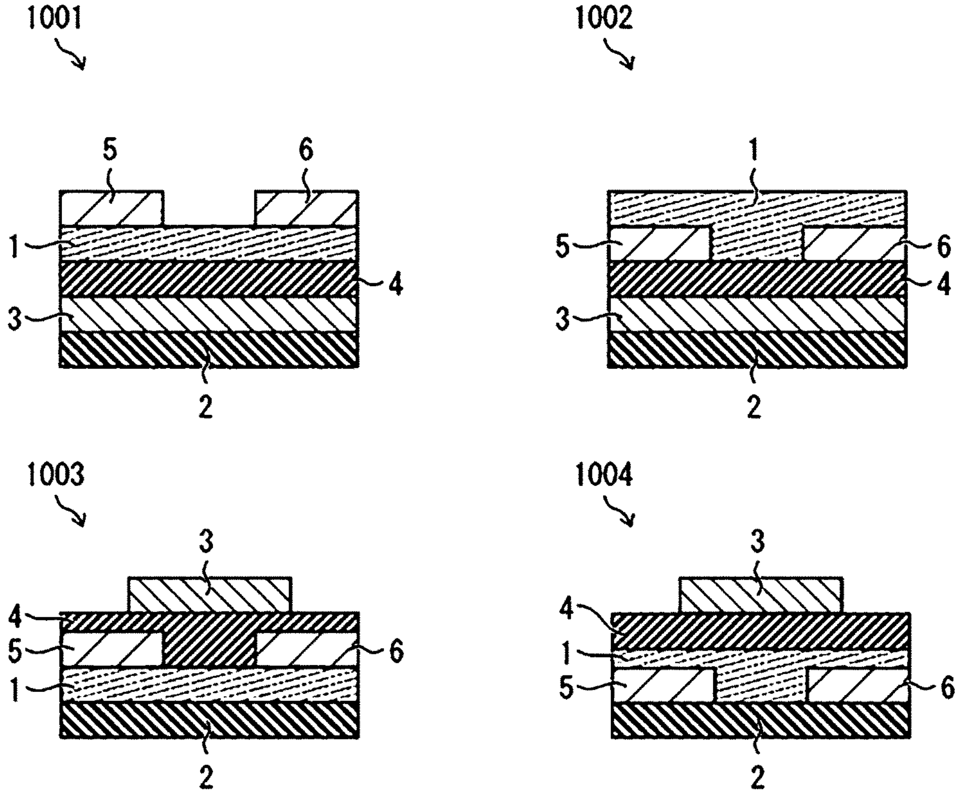


FIG. 2

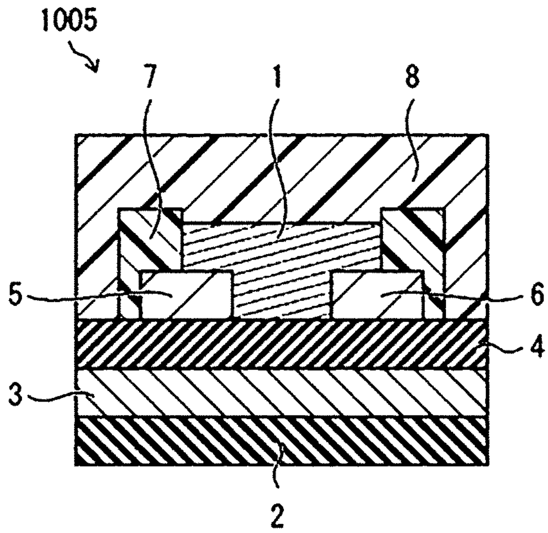

## INTERNATIONAL SEARCH REPORT

International application No.
**PCT/JP2023/034409**

### A. CLASSIFICATION OF SUBJECT MATTER

***C08F 220/30***(2006.01)i; ***C08F 8/00***(2006.01)i; ***C08F 220/22***(2006.01)i; ***C08L 33/14***(2006.01)i; ***C08L 33/16***(2006.01)i; ***G03F 7/027***(2006.01)i; ***H01L 21/336***(2006.01)i; ***H01L 29/786***(2006.01)i; ***H10K 10/40***(2023.01)i; ***H10K 85/00***(2023.01)i
FI: C08F220/30; C08F220/22; C08L33/16; H01L29/78 619A; H10K10/40; H10K85/00; G03F7/027 504; C08F8/00; C08L33/14

According to International Patent Classification (IPC) or to both national classification and IPC

### B. FIELDS SEARCHED

Minimum documentation searched (classification system followed by classification symbols)

C08F220/30; C08F8/00; C08F220/22; C08L33/14; C08L33/16; G03F7/027; H01L21/336; H01L29/786; H10K10/40; H10K85/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 48-8384 A (FUJI PHOTO FILM CO., LTD.) 02 February 1973 (1973-02-02) claims, p. 3, upper right column, structural formula F, examples | 1-3, 5-10<br>4, 11 |
| Y | JP 2019-178191 A (TOSOH CORP) 17 October 2019 (2019-10-17) claims, examples | 4, 11 |
| A | JP 2018-154814 A (TOSOH CORP) 04 October 2018 (2018-10-04) entire text | 1-11 |
| A | JP 48-11102 A (FUJI PHOTO FILM CO., LTD.) 12 February 1973 (1973-02-12) entire text | 1-11 |
| A | WO 2019/003682 A1 (FUJIFILM CORPORATION) 03 January 2019 (2019-01-03) entire text | 1-11 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 November 2023** | **21 November 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2023/034409**

**C. DOCUMENTS CONSIDERED TO BE RELEVANT**

| Category* | Citation of document, with indication, where appropriate, of the relevant passages | Relevant to claim No. |
|---|---|---|
| P, X | WO 2022/210326 A1 (TOSOH CORP) 06 October 2022 (2022-10-06) claims, examples | 1-11 |

Form PCT/ISA/210 (second sheet) (January 2015)

**INTERNATIONAL SEARCH REPORT**
**Information on patent family members**

International application No.
**PCT/JP2023/034409**

| Patent document cited in search report | Publication date (day/month/year) | Patent family member(s) | Publication date (day/month/year) |
|---|---|---|---|
| JP 48-8384 A | 02 February 1973 | (Family: none) | |
| JP 2019-178191 A | 17 October 2019 | (Family: none) | |
| JP 2018-154814 A | 04 October 2018 | US 2021/0135115 A1<br>entire text<br>WO 2018/168676 A1<br>EP 3597673 A1<br>CN 110418808 A | |
| JP 48-11102 A | 12 February 1973 | (Family: none) | |
| WO 2019/003682 A1 | 03 January 2019 | (Family: none) | |
| WO 2022/210326 A1 | 06 October 2022 | TW 202307031 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5932512 B
- JP 6281427 B

### Non-patent literature cited in the description


- *Appl. Phys. Express*, 2014, vol. 7, 101602
- *J Polym Sci A Polym Chem*, 2015, vol. 53, 1252